(19) Europäisches Patentamt
European Patent Office
Office européen des brevets

(11) **EP 2 085 901 B1**

(12) **FASCICULE DE BREVET EUROPEEN**

(45) Date de publication et mention de la délivrance du brevet:
**04.08.2010   Bulletin 2010/31**

(51) Int Cl.:
*G06F 17/50* (2006.01)   *F24J 2/00* (2006.01)

(21) Numéro de dépôt: **08150798.0**

(22) Date de dépôt: **29.01.2008**

(54) **Procédé, dispositif et installation pour l'évaluation du potentiel énergétique électrique d'un champ photovoltaïque sur un site donné**

Verfahren, Vorrichtung und Anlage für die Bewertung des elektrischen Energiepotenzials einer Photovoltaikanlage an einem vorgegebenen Standort

Method, device and installation for assessing the electric energy potential of a photovoltaic plant at a given site

(84) Etats contractants désignés:
**DE ES FR IT**

(43) Date de publication de la demande:
**05.08.2009   Bulletin 2009/32**

(73) Titulaires:
• **Kilowattsol**
  **69004 Lyon (FR)**
• **Ecole Nationale des Travaux Publics de l'Etat (*ENTPE)**
  **69120 Vaulx-en-Velin (FR)**

(72) Inventeurs:
• **Daval, Xavier**
  **69004, Lyon (FR)**
• **Dumortier, Dominique**
  **69200, Venissieux (FR)**

(74) Mandataire: **Cabinet Plasseraud**
  **52, rue de la Victoire**
  **75440 Paris Cedex 09 (FR)**

(56) Documents cités:
  EP-A- 0 883 072        EP-A- 1 677 240
  DE-A1- 10 144 456      US-B1- 6 748 327

**Description**

**Domaine technique de l'invention**

L'invention relève du domaine de l'installation de systèmes solaires photovoltaïques d'alimentation électrique sur des sites divers et isolés ou non.

Plus précisément, l'invention concerne les procédés et les outils d'évaluation du gisement photovoltaïque, c'est-à-dire du potentiel énergétique en production d'électricité, d'un champ photovoltaïque (Cp) destiné à être installé sur un site donné.

De tels procédés et outils sont destinés notamment à des installateurs de champs photovoltaïques Cp contenus dans un plan (P) et destinés à comprendre ou comprenant un ou plusieurs panneaux solaires photovoltaïques (ou module solaire photovoltaïque)

Plus précisément encore, la présente invention vise :

- un procédé d'évaluation du potentiel de production électrique d'un plan (P) d'inclinaison et d'orientation quelconques comprenant ou destiné à comprendre au moins un panneau solaire photovoltaïque(ou module solaire photovoltaïque), ledit panneau étant inclus dans une chaîne de transformation de l'énergie solaire en énergie électrique qui comprend également au moins un onduleur et du câblage;
- un dispositif adapté notamment à la mise en oeuvre du procédé susvisé;
- et une installation pour l'utilisation dudit dispositif

**Etat de la technique**

La demande en systèmes photovoltaïques devrait connaître une croissance significative dans les pays en développement pour satisfaire aux besoins de base des deux milliards de personnes qui n'ont pas encore accès aux réseaux électriques conventionnels. A cette demande en systèmes hors réseaux économiquement rentables, viennent s'ajouter les préoccupations des gouvernements et des services publics à propos de l'environnement et de l'approvisionnement à plus long terme en combustible. En effet, l'épuisement des ressources énergétiques fossiles (pétrole, gaz, charbon) ou fissibles (uranium) et les problèmes de pollution induits par leurs emplois (effet de serre, changement climatique etc.) obligent inéluctablement à recourir aux énergies renouvelables.

L'effet photovoltaïque (PV) permet de convertir l'énergie inépuisable du soleil en électricité. Cette transformation se fait de manière totalement silencieuse, sans mouvement ni usure mécanique. C'est donc une solution particulièrement intéressante pour l'avenir.

Classiquement, un système photovoltaïque comprend :

- un module solaire photovoltaïque comportant au moins un panneau solaire photovoltaïque, un tel module définissant un champ photovoltaïque Cp contenu dans un plan P ;
- une structure portante ou un support prévu pour monter ou installer le module photovoltaïque et les autres composants du système;
- un onduleur, c'est-à-dire un dispositif électrique utilisé pour convertir en courant alternatif, le courant électrique continu produit par les modules PV ;
- éventuellement une batterie d'accumulateurs pour le stockage sous forme chimique de l'énergie produite par les modules photovoltaïques, pour la restituer sous forme électrique selon les besoins (par exemple la nuit ou lors de jours couverts) ;
- et un contrôleur constitué par un dispositif électrique qui gère le stockage de l'énergie dans les accumulateurs et la distribution vers la charge (c'est-à-dire qui contrôle la charge et la décharge des accumulateurs).

Les modules ou panneaux photovoltaïques solaires sont constitués de cellules issues de plaques de silicium cristallin ou de cellules produites selon la technologie en couche mince. Les cellules issues de plaques de silicium cristallin sont encapsulées dans un laminage de verre et de plastique. L'ensemble est ensuite muni d'un cadre et d'une boîte de jonction électrique. Les modules en silicium cristallin courants ont un rendement de conversion $\rho_p$ (énergie électrique produite sur énergie solaire incidente) de l'ordre de 11 à 22%. Les modules en couches minces sont déposés directement sur un substrat de verre ou de plastique et ont un $\rho_p$ de 6 à 8 %.

Les besoins en systèmes photovoltaïques sont potentiellement très importants.

Cependant, en préalable à toute installation d'un système photovoltaïque, il convient d'évaluer les capacités de production d'énergie électrique du champ photovoltaïque, qui sont déterminantes pour la viabilité économique de l'installation concernée.

En effet, la majorité des installations de systèmes photovoltaïques se font sur les toits de résidence principale de particuliers. Or, compte tenu du prix élevé des panneaux solaires photovoltaïques, il est important pour ces particuliers d'effectuer une évaluation préalable pour déterminer la quantité d'électricité susceptible d'être produite par leur toit et ainsi, calculer le temps de retour sur investissement.

En outre, au-delà des performances énergétiques (potentiel énergétique d'un champ photovoltaïque Cp), une telle évaluation doit permettre de déterminer les coûts du système photovoltaïque et de son installation.

Enfin, la connaissance du potentiel de production électrique d'un champ Cp donné doit permettre d'optimiser la conception et le dimensionnement des composants du système.

Dans ce contexte, il serait donc souhaitable de disposer de procédés et d'outils d'évaluation du potentiel de production électrique performants, pour optimiser la précision de l'évaluation et pour réaliser une mesure fine du rendement électrique total du système photovoltaïque envisagé, quels que soient le site et le plan P considéré.

Il importe par ailleurs que ces procédés et ces outils soient robustes et simples d'utilisation pour les installateurs de systèmes photovoltaïques qui n'ont pas les compétences requises pour effectuer des mesures et des calculs sophistiqués. Ces procédés et ces outils d'évaluation auraient également avantage à produire une réponse directement exploitable par ces installateurs et par leurs clients, dans le cadre d'un processus d'aide à la décision d'investissement.

D'où il s'ensuit que la présente invention a notamment pour essence la question suivante: Comment déterminer de façon précise, fiable et simple le potentiel de production d'électricité d'un site destiné à recevoir un champ Cp compris dans un plan P d'inclinaison et d'orientation quelconques.

Parmi les propositions techniques existantes qui tentent vainement de répondre à la question ci-dessus, on peut citer le système et le procédé de détection de l'énergie solaire in situ divulguée par la demande de brevet chinois CN 1664516. Dans ce procédé, il est prévu de prendre une photographie du lieu considéré, à l'aide d'un appareil photographique muni d'un objectif du type *fish eye,* en s'assurant que l'angle d'altitude et l'angle d'azimut de chaque point de la photographie satisfont aux lois de l'imagerie. Le procédé consiste ensuite à projeter sur la photographie la course solaire locale correspondant à la latitude géographique du lieu de mesure, à corréler cette course solaire locale avec les données d'orientation et à mesurer les conditions d'ensoleillement de l'environnement du lieu de mesure pour une année. A partir du temps d'exposition ainsi obtenu, le procédé selon CN 1664516 consiste à calculer l'intensité des rayonnements solaires en tenant compte de l'angle d'altitude solaire et de la transmission atmosphérique. Le procédé selon CN 1664516 permet de mesurer l'intensité des rayonnements solaires du lieu concerné sur une surface de niveau ou sur une surface verticale à un temps de donné et de s'assurer qu'il s'agit de la meilleure surface pour capter l'énergie solaire. CN 1664516 décrit donc l'acquisition d'une image hémisphérique et la superposition du parcours du soleil sur cette image. Il doit être noté que la photographie est prise dans un plan horizontal. Il s'agit seulement selon CN 1664516, de faire coïncider sur la photographie hémisphérique, le parcours du soleil, puis d'en déduire pas à pas, la présence ou non du soleil. Ce procédé ne tient nullement compte des variables fondamentales que sont l'énergie solaire et les variations climatiques. Il n'est pas question de calcul du potentiel énergétique électrique d'un système photovoltaïque, pas plus que de l'influence de l'ombrage provoqué par les obstacles voisins du lieu de mesure.

La demande de brevet japonais JP-5066153 divulgue une méthode de mesure de la quantité de lumière reçue et les conditions d'ensoleillement d'un site prospectif d'installation d'un système photovoltaïque. Ce procédé consiste à superposer sur la photographie de l'environnement du site pris à l'aide d'un appareil photographique à objectif *fish eye,* l'image du parcours du soleil, en réalisant une cartographie à l'aide d'un ordinateur. L'influence des saisons, de la météo, et des paramètres de positionnement du site dans l'espace, n'est pas prise en compte.

Le brevet américain US-B-6 748 327 décrit un procédé pour l'évaluation spatiale de la densité de flux des radiations solaires et d'autres variables météorologiques corrélées à l'ensoleillement pour une localisation géographique identifiée par sa latitude et sa longitude à l'intérieur d'une région géographique incluant un réseau synchrone d'une pluralité de stations météorologiques comprenant des instruments nécessaires à l'acquisition ou au calcul des variables ainsi qu'une base de données comprenant des valeurs météorologiques historiques quotidiennes pour les variables considérées, et ce sur des périodes de temps spécifiques et sur un certain nombre d'années. Il s'agit donc dans US-B-6 748 327 de mettre en oeuvre une méthode d'auto-apprentissage de l'ensoleillement d'un site donné à partir de valeurs provenant d'un réseau de stations météorologiques au sol. Ce procédé statistique multi-variable peut être assimilé à un algorithme pour estimer la densité du flux des rayonnements solaires ou de toute variable solaire corrélée, pour tout lieu à l'intérieur d'une région qui comprend un réseau synchrone de stations météo au sol et une base de données de valeurs moyennes horaires historiques de toutes les variables météorologiques. Le calcul par ordinateur de tous les points de la grille cartographique de la région permet d'établir une carte de la densité du flux de radiations solaires en watts par m$^2$. Les variables solaires corrélées disponibles dans le réseau selon le procédé du brevet US-B-6 748 327 sont : la température de l'air, la pression de vapeur d'eau, transpiration de référence, la vitesse du vent.

La demande de brevet allemand DE-A-10144456 divulgue une méthode de détermination de la quantité d'ensoleillement d'une localisation géographique donnée, à partir de la détermination du masque d'ombrage obtenu soit par une photographie dans le plan horizontal au moyen d'un objectif photographique du type *fish eye,* soit par une photographie dans le plan vertical avec un objectif photographique grand angle. Les variables météorologiques ne sont nullement prises en compte.

La demande EP1677240-A2 divulgue un système d'assistance pour installer un générateur photovoltaïque de puissance comprenant des modules photovoltaïques et des moyens de calcul permettant, sur la base d'informations géographiques, de déterminer une zone d'installation desdits modules. En particulier, ce système comporte une base de données d'images géographiques stockant des images géographiques et des coordonnées : des moyens de saisie du site de l'installation des modules, des moyens d'affichage d'images géographiques notamment de l'image géographique du site d'installation, ces moyens d'affichage étant aptes à extraire cette image géographique de la base de données d'images géographique à partir de la position du site d'installation, des moyens de saisie de la surface d'installation des modules sur l'image géographique affichée, des moyens d'indication de la forme de la surface d'installation des modules par extraction des coordonnées de la surface d'installation à partir de la base de données d'images géographiques, des moyens de détermination de module pour déterminer un type et une mise en place des modules, qui soient appropriés pour la forme de la surface d'installation et des moyens d'évaluation aptes à extraire les prix des modules mis en place à partir d'une base de données stockant les prix de modules photovoltaïques et aptes à calculer un prix estimatif d'un coût d'installation du générateur.

## Objectifs de l'invention

Dans un tel état de la technique, l'un des objectifs essentiels de la présente invention est de fournir un procédé d'évaluation du potentiel de production électrique d'un plan (P) d'inclinaison et d'orientation quelconques et comprenant ou destiné à comprendre au moins un panneau solaire photovoltaïque (ou module solaire photovoltaïque), ledit panneau étant inclus dans une chaîne de transformation de l'énergie solaire en énergie électrique qui comprend également au moins un onduleur et du câblage, remédiant aux inconvénients des systèmes connus, en particulier au regard de la précision et de la fiabilité des résultats obtenus.

Un autre objectif essentiel de la présente invention est de fournir un procédé d'évaluation du potentiel énergétique d'un champ photovoltaïque Cp contenu dans un plan P d'inclinaison et d'orientation quelconques et destiné à comprendre ou comprenant au moins un panneau solaire photovoltaïque (ou module solaire photovoltaïque), qui soit rapide et simple à mettre en oeuvre par un opérateur non qualifié en métrologie et qui puisse être aisément automatisé.

Un autre objectif essentiel de l'invention est de fournir un dispositif, notamment pour la mise en oeuvre du procédé susvisé, ledit dispositif se devant à la fois d'être simple à utiliser et robuste, et de concourir à l'atteinte des objectifs ci-dessus énumérés.

Un autre objectif essentiel de la présente invention est de fournir une installation pour l'utilisation du dispositif susvisé, ladite installation se devant d'être économique et de permettre la mise en oeuvre simple, rapide et pratique du dispositif susvisé.

## Description succincte de l'invention

Ces objectifs, parmi d'autres, sont atteints par la présente invention qui concerne tout d'abord, un procédé d'évaluation du potentiel de production électrique d'un plan (P) d'inclinaison et d'orientation quelconques, et comprenant ou destiné à comprendre au moins un panneau solaire photovoltaïque, ledit panneau étant inclus dans une chaîne de transformation de l'énergie solaire en énergie électrique qui comprend également au moins un onduleur et du câblage, caractérisé en ce qu'il consiste essentiellement :

1000 à mettre en oeuvre au moins un boîtier (100) intelligent de caractérisation automatique de P et de l'environnement dudit plan P, ce boîtier (100) étant posé dans le plan P;

2000 à lancer au moyen du boîtier (100) un processus d'acquisition des données suivantes :

2100 localisation de P par sa latitude et sa longitude et, de préférence son altitude ;

2200 orientation et inclinaison de P;

2300 capture optique de la composition de l'environnement tel qu'il est vu du plan P [de préférence photographie(s) panoramique(s)];

2400 date et heure de l'acquisition ;

3000 éventuellement à stocker tout ou partie des données 2100, 2200, 2300, 2400 acquises à l'étape 2000, en vue d'un transfert ultérieur sur un serveur (400) de traitement dédié;

4000 à transférer les données 2100, 2200, 2300, 2400 acquises à l'étape 2000 sur le serveur (400) de traitement dédié ;

5000 à traiter des données, notamment les données 2100, 2200, 2300, 2400 acquises à l'étape 2000, au moyen du serveur (400) de traitement dédié, pour calculer le potentiel de production électrique de P, ce traitement de données comprenant les sous-étapes suivantes :

5100 traitement des données 2100, 2200, 2300, 2400 acquises à l'étape 2000 et transmises à l'étape 4000, pour localiser et déterminer l'influence des obstacles sur les rayonnements solaires direct et diffus auxquels est éventuellement exposé le plan P, ces obstacles situés dans l'environnement de P étant décrits par leur aptitude à réfléchir, transmettre ou bloquer le rayonnement solaire direct ou diffus; il en va de même pour l'influence du sol ;

5200 échange d'informations entre un opérateur et le serveur ;

5300 extraction de données microclimatiques comprenant l'énergie solaire directe et diffuse et éventuellement la température de l'air, pour la localisation 2100 de P, et ce à un pas de temps Pt inférieur ou égal à 24 heures, de préférence inférieur ou égal à 1 heure, et pour une période Pe d'au moins une année pleine ;

5400 calcul itératif et dynamique du potentiel de production électrique de P, à un pas de temps Pt' inférieur ou égal à 24 heures, de préférence inférieur ou égal à 1 heure, et plus préférentiellement encore inférieur ou égal à 30 minutes et pour une période Pe' d'au moins une année pleine, (de préférence Pt' & Pe' étant respectivement et indépendamment égaux à Pt & Pe) par mise en oeuvre des phases suivantes :

5410 calcul de la totalité de l'énergie solaire reçue par P en tenant compte de l'influence des obstacles localisés en 5100 et du sol sur les rayonnements solaires direct et diffus;

5420 calcul de l'énergie électrique produite par la chaîne de transformation, à partir de l'énergie solaire calculée en 5410 en tenant compte:

5421 du rendement du (ou des) panneau(x), en intégrant éventuellement dans ce rendement la température de surface du (ou des) panneau(x) obtenue à partir de la température extraite éventuellement en 5300;

5422 et éventuellement des pertes supplémentaires dues à (aux) onduleur(s) et au câblage,

6000 à éditer les résultats des calculs sous forme de rapport(s), de préférence transmis au boîtier (100) et/ou présentés sur l'écran du serveur et/ou imprimés.

Ce nouveau procédé d'évaluation du gisement photovoltaïque, c'est-à-dire du potentiel énergétique (production électrique = productible électrique) d'un site, et plus particulièrement d'un plan P de ce site destiné à accueillir un champ photovoltaïque Cp, est précis, fiable, économique, rapide et automatique.

Ce procédé simple peut être mis en oeuvre par un opérateur non familier des techniques de métrologie, en particulier par un installateur de systèmes photovoltaïques. Il lui permet d'optimiser son offre technique et commerciale, notamment en étant capable d'indiquer au client le temps de retour sur investissement du système photovoltaïque, ce qui facilite la prise de décision d'achat par le client. Les données produites par le procédé selon l'invention sont directement exploitables par eux et par leurs clients.

La quantité d'électricité produite annuellement par le système dépend certes du choix des panneaux et des équipements de conversion électrique (onduleurs), mais également du positionnement des panneaux sur le toit (intégration, inclinaison, orientation) et de la quantité d'énergie solaire susceptible de frapper le champ de panneaux au cours de l'année. L'énergie solaire arrivant sur les panneaux est variable car le soleil bouge (mécanique solaire parfaitement connue pour un lieu donné), son rayonnement direct est affecté par la clarté du ciel (liée à la météo et à la composition de l'atmosphère à un instant donné) et par d'éventuels obstacles qui masquent le soleil à certaines heures de la journée. Son rayonnement diffus est également affecté par la clarté du ciel et par les réflexions apportées par l'environnement direct du site. De plus, le rendement de conversion électrique d'une cellule photovoltaïque est lié à sa température de fonctionnement.

Or, un des éléments intéressants de ce procédé selon l'invention est d'opérer une fusion de données de localisation (latitude/longitude/altitude de P), de données de positionnement dans l'espace du plan P compris dans Cp, de données photographiques de l'environnement, toutes ces données étant acquises par des mesures de terrain simple, d'une part, et de données microclimatiques précises fiables obtenues de préférence à partir d'images satellites, d'autre part. Le fait que les données climatiques utilisées dans le procédé selon l'invention soient des données microclimatiques provenant de préférence de radiomètres implantés dans les satellites géostationnaires et plutôt que provenant de stations de mesures au sol, est un avantage déterminant.

Il est également à noter que le procédé selon l'invention tient compte du fait que la quantité d'énergie solaire disponible sur le site de P doit être adaptée à ce que reçoit localement P compte tenu de son inclinaison, de son orientation, de son installation sur le site e.g. un toit (encastré ou en superstructure) et des obstacles environnants (immeubles, végétation, montagnes, etc) qui atténuent le rayonnement solaire disponible sur P, de manière permanente ou temporaire (certaines heures du jour et certains jours de l'année). Il est donc essentiel conformément au procédé de l'invention, de prendre en considération l'impact de l'environnement immédiat du site de P dans le calcul de l'énergie disponible pour P. Il est donc du mérite des inventeurs d'avoir intégré ce paramètre dans le procédé selon l'invention.

Le procédé selon l'invention tient également compte des caractéristiques des cellules photovoltaïques concernées et/ou de la structure du champ photovoltaïque Cp concerné et/ou de la température des cellules, laquelle est dépendante de la température extérieure et des caractéristiques des cellules.

Selon un autre de ses aspects, la présente invention concerne un dispositif notamment pour la mise en oeuvre du procédé ci-dessus défini, pour l'évaluation du potentiel de production électrique d'un plan (P) d'inclinaison et d'orientation quelconques comprenant ou destiné à comprendre au moins un panneau solaire photovoltaïque, ledit panneau étant inclus dans une chaîne de transformation de l'énergie solaire en énergie électrique qui comprend également au moins un onduleur et du câblage, caractérisé en ce qu'il comprend

➢ un boîtier (100) intelligent de caractérisation automatique de P et de l'environnement dudit plan P contenant notamment:

■ (110) un système de géo-positionnement satellitaire apte à fournir des données de localisation de P;

■ (120) au moins deux inclinomètres (avantageusement électroniques), de préférence au moins trois accéléromètres formant un trièdre (x, y, z), dont deux des axes (x, y) sont dans le plan de référence P et permettant la mesure des 3 composantes $(g_x, g_y, g_z)$ du vecteur gravitationnel $\vec{g}$, lequel permet d'accéder au vecteur de plus grande pente de P et à la pente $\alpha$ (2210) (inclinaison de P) de son vecteur de plus grande pente, par rapport à l'horizontale;

■ (130) au moins une boussole (avantageusement électronique) de préférence une boussole comprenant au moins trois capteurs magnétiques perpendiculaires entre eux formant un trièdre (x', y', z'), de préférence identique au trièdre (x, y, z) permettant de mesurer les coordonnées $(B_x, B_y, B_z)$ du vecteur du champ magnétique terrestre $\vec{B}$ dans le repère (x, y, z), lesquelles coordonnées permettant d'accéder à l'azimut $\beta$ (orientation de P) du vecteur de plus grande pente de P;

■ (140) au moins un appareil de photographie ou caméra numérique équipé d'un objectif de type "*fish-eye*" dont l'angle du champ de vision est d'au moins 180˚, de préférence au moins un capteur CCD, apte à prendre au moins une photographie de l'environnement de P, vu du plan P;

■ (150) une unité électronique comprenant :

- 151 au moins une mémoire de stockage permettant notamment l'archivage des données acquises à l'étape 2000;
- 152 au moins un processeur de calcul et d'exécution d'au moins l'une des étapes 2000, 3000 et 4000 (de préférence toutes);
- 153 au moins un port de connexion et d'identification;
- 154 éventuellement une horloge temps réel;
- 155 éventuellement au moins un organe de commande, de préférence au moins un bouton poussoir et/ou au moins une télécommande;
- 156 une alimentation électrique, de préférence une batterie;

➢ au moins un serveur (400) dédié auquel ledit boîtier (100) peut être connecté chaque fois qu'il s'agit d'évaluer le potentiel de production électrique d'un plan P, ledit serveur (400) étant susceptible d'être connecté à internet et notamment à une base de données microclimatiques et comprenant au moins un ordinateur, de préférence un ordinateur personnel, situé sur un site de l'opérateur et/ou au moins un système informatique délocalisé sur un site internet; l'éventuel système informatique délocalisé compris dans le serveur (400) et la base de données microclimatiques étant de préférence accessibles via internet sur un site internet approprié;

ledit serveur (400) comprenant de préférence des moyens de saisie et de transmission au serveur, d'une part, d'un ou plusieurs paramètres choisis dans le groupe comportant: l'identification de l'opérateur, la création de projet, la gestion de projets en cours, et, d'autre part, de paramètres nécessaires au calcul et choisis dans le groupe comprenant les caractéristiques des cellules comprises dans le ou les panneaux solaires photovoltaïques et le type de panneau(x) envisagé(s) (par exemple encastré ou en superstructure).

Un tel dispositif est simple d'utilisation, précis, fiable et économique.

Le boîtier (100) de ce dispositif est un élément mobile utilisable pour l'acquisition des données sur les différents sites candidats à l'installation de systèmes photovoltaïques. Ce boîtier (100) est facilement transportable et s'utilise facilement par dépose sur le lieu destiné à recevoir le Cp dans le plan P, par exemple un toit de bâtiment. Il est robuste et permet d'effectuer des mesures fiables.

Le serveur (400) est de préférence délocalisé par rapport au site comprenant le plan P destiné à recevoir le champ Cp.

Dans un autre de ses aspects, la présente invention concerne une installation pour l'utilisation du dispositif susvisé dans le cadre de la mise en oeuvre du procédé tel que défini ci-dessus. Cette installation est caractérisée en ce qu'elle comprend le boîtier (100) et au moins une perche (200) (de préférence télescopique) de dépose dudit boîtier (100) sur la surface (e.g. un toit) comprenant le plan P; ledit boîtier (100) étant de préférence celui défini ci-dessus et ladite perche (200) comportant à l'une de ses extrémités, un anneau (230) auquel le boitier (100) peut être suspendu par l'intermédiaire de sa longe (170) et de son crochet (175).Cette installation est utile pour la mise en place du boîtier (100) d'acquisition des données sur des endroits difficilement accessibles, notamment du fait de leur hauteur par rapport au sol et de leur déclivité, comme par exemple les toits de bâtiment. Cette installation simple vise à faciliter l'utilisation du dispositif et la mise en oeuvre du procédé selon l'invention.

**Description détaillée de l'invention**

L'exposé qui suit apporte des précisions sur les caractéristiques préférées de l'invention et fournit un exemple de mise en oeuvre du procédé selon l'invention et un exemple de réalisation et de mise en oeuvre du dispositif et l'installation selon l'invention, en référence aux figures annexées.

Description des figures

**La figure 1** représente un schéma illustrant le mode préféré de mise en oeuvre de l'invention dans lequel un boîtier intelligent est déposé sur un plan P, par exemple un toit de bâtiment, destiné à recevoir le champ photovoltaïque Cp, ce schéma comprenant par ailleurs une boussole représentée symboliquement pour expliquer le mode de détermination de l'angle β.

**La figure 2** représente un exemple de photographie "*fish-eye*" 180˚ prise depuis un plan P donné.

**La figure 3** est une vue de dessus de ¾ du boîtier intelligent selon l'invention.

**La figure 4** est une vue de dessus du boîtier intelligent de la figure 3.

**La figure 5** est une vue de côté selon la direction V montrée sur la figure 4 avec arrachement et coupe partielle montrant l'intérieur du boîtier (100).

**La figure 6** illustre de manière schématique, l'utilisation de l'installation selon l'invention pour la dépose sur un plan P destiné à recevoir Cp, à savoir sur un toit de bâtiment, avant la dépose du boîtier intelligent sur le toit.

**La figure 7** illustre la situation qui suit celle montrée à la figure 6, à savoir la situation dans laquelle le boîtier intelligent est déposé sur le toit.

Glossaire

| | |
|---|---|
| AZIS | Angle d'azimut du soleil par rapport au nord. |
| EHD | Eclairement énergétique de la voûte céleste sur un plan horizontal. |
| ENS | Eclairement énergétique dans un plan normal au soleil. |
| EPC | Eclairement énergétique sur le plan P dû au ciel. |
| EPRM | Eclairement énergétique sur le plan P dû aux réflexions sur les masques. |
| EPRS | Eclairement énergétique sur le plan P dû aux réflexions sur le sol. |
| EPS | Eclairement énergétique sur le plan P dû au soleil. |
| GAMS | Angle d'incidence entre le soleil et le plan P. |
| GLEZC | Luminance énergétique globale d'une zone du ciel (TLEZC+RLEZC). |
| LEMR | Luminance énergétique d'un masque due à la réflexion du rayonnement solaire direct. |
| LEZC | Luminance énergétique d'une zone du ciel. |
| NATM | Nature des masques |
| REFM | Facteur de réflexion d'un masque. |
| REFS | Facteur de réflexion du sol. |
| REFZC | Facteur de réflexion d'une zone du ciel. |
| RENP | Rendement des panneaux photovoltaïques. |
| RLEZC | Luminance énergétique d'une zone du ciel résultant des réflexions sur le masque. |
| TAE | Température de l'air extérieur. |
| TDM | Tableau de description des masques, contour, transmission et réflexion. |
| TDZC | Tableau de description des zones du ciel. |
| TLEZC | Luminance énergétique transmise par une zone du ciel. |
| TP | Température des panneaux photovoltaïques. |
| TRAM | Facteur de transmission d'un masque. |
| TRAZC | Facteur de transmission d'une zone du ciel. |
| ZENS | angle au zénith du soleil. |

**Le procédé selon l'invention**

Etape 1000 : dépose du boîtier (100)

L'étape 1000 consiste à poser le boitier (100) sur le plan P, au moyen d'au moins un outil (200) (de préférence une perche) de dépose.

De préférence, le boîtier (100) est posé sur la surface définissant le plan P de telle sorte que la base du boîtier (100) soit coplanaire à P.

Ce boîtier (100) permet d'acquérir en une seule passe et sans aucun réglage, toutes les données nécessaires au calcul du potentiel de production électrique.

Le boîtier (100) est sur P au moins le temps nécessaire à l'acquisition des données selon l'étape 2000.

Le boîtier (100) est conçu de façon à disposer d'une surface de contact parfaitement plane et suffisamment large pour offrir un maximum de points de contacts avec le plan P. Le plan P est par exemple un toit constitué de tuiles, d'ardoises, de métal type bac-acier. L'étape 1000 mise en oeuvre du système par un seul opérateur sans monter sur le toit, donc sans prise de risques superflus dans la phase de pré-diagnostic.

Cette étape 2000 est nécessaire à la mesure du potentiel de production électrique est de caractériser le plan P qui recevra les panneaux. Il s'agit soit d'un espace nu (typiquement un champ ou un toit terrasse) soit de la toiture d'un bâtiment existant.

Etape 2000 : Acquisition des données

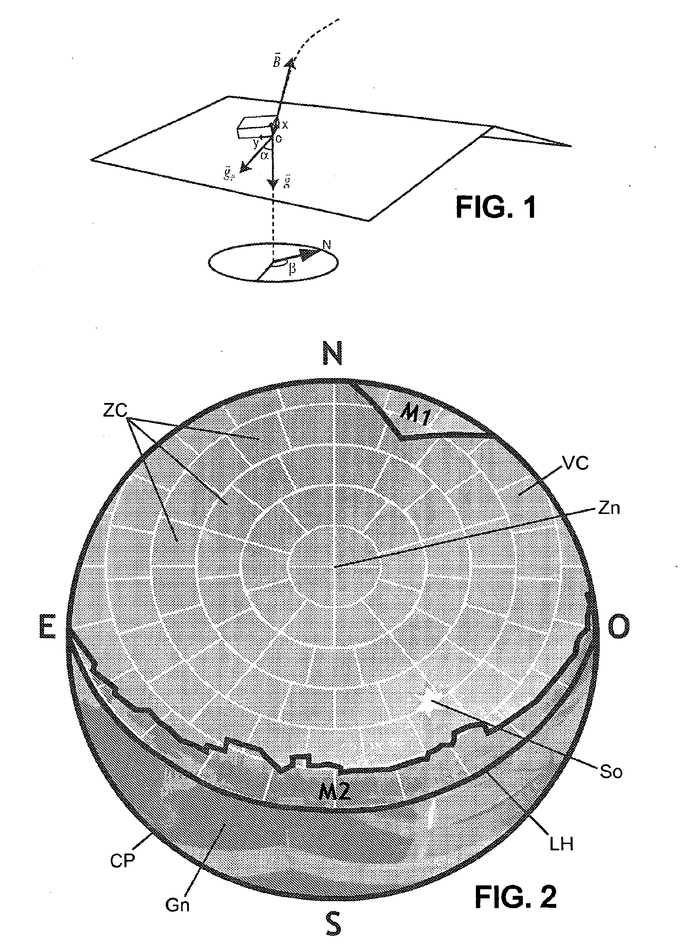

Cette étape est pilotée à l'aide d'une unité électronique (105) comprise dans le boîtier (100). Elle peut être déclenchée par exemple au moyen d'un organe de commande (155) e.g. un bouton poussoir de préférence associé à un retardateur ou mieux d'une télécommande que l'opérateur actionne quand le boîtier (100) est en place sur le plan P. Ce déclenchement met en route une série d'actions nécessaires à la caractérisation de P. On se référera dans ce qui suit à la figure 1 annexée.

De préférence, l'étape 2000 d'acquisition des données consiste essentiellement à :

2100 déterminer la longitude, la latitude et éventuellement l'altitude de P au moyen d'un système de géo-positionnement satellitaire (GPS);

2200 déterminer :

→ 2210 : d'une part, l'inclinaison de P par rapport à la verticale du lieu au travers de l'angle par rapport à l'horizontale [pente $\alpha$ (2210) cf fig.1] de son vecteur de plus grande pente, de préférence au moyen d'au moins deux inclinomètres électroniques, et, plus préférentiellement encore au moyen d'au moins trois accéléromètres perpendiculaires entre eux, formant un trièdre (x, y, z) -cf. fig 1-,dont deux des axes (x, y) sont dans le plan de référence P et permettant la mesure des 3 composantes ($g_x$, $g_y$, $g_z$) du vecteur gravitationnel $\vec{g}$ -cf. fig 1-, qui définit la verticale du lieu et dont la projection $\vec{g}_P$ =($g_x$, $g_y$, 0) -cf fig 1- dans le plan P, donne le vecteur de plus grande pente, la pente $\alpha$ entre $\vec{g}$ et $\vec{g}_P$ étant donnée par $\cos(\alpha) = \dfrac{\sqrt{g_x^2 + g_y^2}}{\sqrt{g_x^2 + g_y^2 + g_z^2}}$

→ 2220 : et, d'autre part, l'orientation de P au travers de son azimut $\beta$ (2220) -cf. fig 1- de préférence l'azimut $\beta$ de son vecteur de plus grande pente par rapport au nord (avantageusement le nord magnétique), au moyen d'une boussole, de préférence une boussole constituée par un système de mesure du champ magnétique terrestre comprenant au moins trois capteurs magnétiques perpendiculaires entre eux formant un trièdre (x', y', z'), de préférence identique au trièdre (x, y, z), dont deux axes (x, y) sont dans le plan de référence P et permettant de mesurer les coordonnées ($B_x$, $B_y$, $B_z$) du vecteur du champ magnétique terrestre $\vec{B}$ dans le repère (x, y, z) -cf fig 1-;

le boîtier (100) intelligent définissant ensuite:

- un vecteur $\vec{A}$ perpendiculaire à $\vec{B}$ et $\vec{g}$ :

$$\vec{A} = \vec{B} \wedge \vec{g} = \begin{pmatrix} B_y g_z - g_y B_z \\ -B_x g_z + g_x B_z \\ B_x g_y - g_x B_y \end{pmatrix} = \begin{pmatrix} A_x \\ A_y \\ A_z \end{pmatrix}$$

- un vecteur $\vec{H}$ perpendiculaire à $\vec{A}$ et $\vec{g}$ :

$$\vec{H} = \vec{A} \wedge \vec{g} = \begin{pmatrix} A_y g_z - g_y A_z \\ -A_x g_z + g_x A_z \\ A_x g_y - g_x A_y \end{pmatrix} = \begin{pmatrix} H_x \\ H_y \\ H_z \end{pmatrix}$$

$\vec{H}$ est la composante de $\vec{B}$ dans le plan horizontal communément dénommée « Nord magnétique »;
- la composante de $\vec{g}_P$ dans le plan horizontal $(\vec{A},\vec{H})$ à savoir $\vec{G}$:

$$\vec{G} = \frac{g_x A_x + g_y A_y}{A_x^2 + A_y^2 + A_z^2} \times \begin{pmatrix} A_x \\ A_y \\ A_z \end{pmatrix} + \frac{g_x H_x + g_y H_y}{H_x^2 + H_y^2 + H_z^2} \times \begin{pmatrix} H_x \\ H_y \\ H_z \end{pmatrix} = \begin{pmatrix} G_x \\ G_y \\ G_z \end{pmatrix}$$

et calculant enfin l'azimut β (2220) entre la direction du nord magnétique $\vec{H}$ et $\vec{G}$ à partir de la formule suivante :

$$\cos(\beta) = \frac{g_x H_x + g_y H_y}{\sqrt{H_x^2 + H_y^2 + H_z^2} \times \sqrt{G_x^2 + G_y^2 + G_z^2}}$$

2300 effectuer la capture optique de la composition de l'environnement tel qu'il est vu du plan P au moyen d'un appareil photo numérique ou d'une caméra équipé d'un objectif dont l'angle du champ de vision est d'au moins 180° (type "*fish-eye*") en réalisant une série d'au moins une, de préférence au moins 4 et, plus préférentiellement encore au moins 6 photos (par exemple consécutives), tout ou partie de ces photos étant de préférence prises avec des temps d'ouverture différents, pour permettre d'obtenir en combinant la ou les photos, l'image la plus détaillée de l'environnement de P,
2400 procéder à l'horodatage de tout ou partie des informations au moyen d'une horloge intégrée sur une carte électronique du boîtier (100).

Sous-étape 2100

Cette localisation géographique du plan P renvoie les coordonnées en longitude, latitude et éventuellement altitude du site. Ces informations peuvent être obtenues de façon automatique au moyen d'un dispositif de localisation par satellite (par exemple GPS).
Ces coordonnées peuvent également être obtenues, entre autres, à partir de l'adresse du site comprenant P et en croisant cette adresse avec d'autres informations en provenance d'un logiciel de cartographie (type Google Earth™ ou Géoportail™).
L'altitude peut aussi être accessible e.g. via une base de données altimétrique, telle que celle issue des missions SRTM (Shuttle Radar Topography Mission) de la navette spatiale américaine, et en la déduisant des coordonnées du site.

Sous-étape 2200

Toutes les méthodes existantes aujourd'hui fonctionnent pour un plan P horizontal ou proche de l'horizontal et il est en outre impératif dans ces méthodes connues d'orienter manuellement l'appareil de mesure utilisé vers le sud (ou le nord dans l'hémisphère sud). Contrairement à cela, le procédé selon l'invention fonctionne quelles que soient l'inclinaison et l'orientation du plan P, car il est prévu dans cette étape 2200 de déterminer automatiquement ces données au travers de la pente ($\alpha$) et de l'azimut ($\beta$) du plan P.

La pente ($\alpha$), c'est-à-dire l'inclinaison, est l'angle le vecteur $\vec{g}_P$ de plus grande pente du plan P et le vecteur gravitationnel $\vec{g}$. Pour l'azimut ($\beta$), on détermine l'orientation du vecteur $\vec{g}_P$ de plus grande pente du plan P l'axe de plus grande pente par rapport au nord magnétique, de préférence à l'aide du système de mesure du champ magnétique terrestre comprenant au moins trois capteurs magnétiques. Ces derniers permettent de mesurer toutes les composantes du champ magnétique terrestre qui est très faible. Ceci permet également de connaître l'angle de pénétration de $\vec{B}$ dans le plan horizontal.

Il est possible de vérifier si le champ magnétique n'est pas perturbé par la présence de masses ferromagnétiques sur le site (par exemple poutrelles métalliques dans la structure comprenant P, e.g. le toit). Ainsi, lors de la mesure de l'azimut $\beta$ (2220), on détermine l'angle de pénétration de $\vec{B}$ dans le plan horizontal à l'aide de la boussole et si cet angle de pénétration présente une dérive de plus de p % (de préférence p = 10 ou mieux encore p = 5) par rapport à la valeur de référence locale de l'angle de pénétration de $\vec{B}$, de préférence, issue d'une base de données telle celle du National Geographical Data Center (NGDC), alors la valeur calculée de $\beta$ est réputée fausse.

Sous-étape 2300

Les rayonnements lumineux peuvent être bloqués par des obstacles à certaines heures de la journée et/ou à certains jours de l'année. C'est pourquoi il est avantageusement prévu selon l'invention, d'identifier ou de capturer l'environnement Il s'agit de procéder à une caractérisation des obstacles proches ou lointains susceptible d'interférer avec l'énergie incidente. Cette capture peut se faire au moyen d'un capteur optique de type CCD équipé d'un objectif "*fish-eye*" dont le champ de vision d'au moins 180˚ permet d'acquérir sur 360˚ la vision panoramique telle que vu par le plan quelconque P. Il doit être souligné que cette acquisition est réalisée directement depuis le plan P, sans orientation ni alignement par rapport à l'horizontale. La caractérisation est par exemple effectuée par une série d'au minimum 4 et typiquement 6 photos consécutives prises avec un temps d'ouverture croissant progressivement pour capturer le maximum de détails quelle que soit la luminosité ambiante.

Les données 2100, 2200 acquises précédemment peuvent permettre ultérieurement de faire tourner la photo autour de son axe.

De plus, en faisant l'acquisition depuis le plan P, on obtient une vision en deçà de l'horizon pour la partie qui est à l'avant de la ligne de plus grande pente. Comme expliqué plus loin, cette zone peut servir de référence pour caractériser le sol.

Sous-étape 2400

Avantageusement, l'horloge intégrée sur une carte électronique du boîtier (100) peut être synchronisée sur l'heure universelle transmise e.g. par le système GPS.

Etape facultative 3000 : Stockage des données

Suivant une modalité intéressante de l'étape facultative 3000, tout ou partie des données 2100, 2200, 2300, 2400 acquises à l'étape 2000 sont stockées dans au moins une unité de mémoire du boîtier (100) comprenant au moins l'un des éléments suivants : RAM, EEPROMM, Flash, disque dur.

Etape 4000 : Transmission des données au serveur (400)

Dans l'étape 4000, tout ou partie des données 2100, 2200, 2300, 2400 acquises à l'étape 2000 sont de préférence transmises au serveur (400) de traitement dédié au moyen d'un système de communication destiné à dialoguer avec ledit serveur (400), la communication étant de préférence une liaison filaire et/ou non filaire, de préférence choisie dans le groupe de liaisons comprenant les liaisons filaire série (RS232, RS485), les liaisons filaire USB, les liaisons non filaires utilisant un standard de communication de type GSM, WiFi, Blue-Tooth ou Wimax; cette transmission s'opérant directement vers le serveur de traitement ou via un PC intermédiaire qui serait relié à un réseau étendu de type haut-débit.

Avantageusement, les données 2100, 2200 et/ou 2300 du boitier (100) peuvent être transférées vers le serveur (400):

→ directement (4100),
→ et/ou par l'intermédiaire d'un ordinateur (4200).

Selon une forme préférée F1 de mise en oeuvre, le serveur (400) est constitué par au moins un système informatique délocalisé sur un site internet et les sous-étapes 4100 et/ou 4200 sont applicables.

Selon une variante F2 de cette forme préférée de mise en oeuvre, le serveur (400) est constitué par au moins un ordinateur personnel (PC) situé sur un site de l'opérateur, la sous-étape 4100 étant alors la plus simple.

Selon une autre variante F3 de cette forme préférée de mise en oeuvre, le serveur (400) est constitué par au moins un système informatique délocalisé sur un site internet et par au moins un ordinateur personnel (PC) situé sur un site de l'opérateur, les sous-étapes 4100 et 4200 étant applicables séparément ou ensemble.

Dans tous les cas, il est préférable que la connexion au serveur (400) nécessite une identification (4300).

De préférence, le système informatique délocalisé sur internet qui constitue le serveur (400), ainsi que la base de données microclimatiques utilisée en 5300, sont chacun accessibles via internet sur un site internet approprié. Il peut d'ailleurs s'agir du même site internet.

Sous-étape 4100

Pour l'exécution de cette étape 4100 dans la forme F1 de mise en oeuvre, le boîtier (100) inclut par exemple un module de communication type GPRS ou 3G. Ce module permet au dit boîtier (100) de se connecter directement au serveur (400) via le réseau internet. Le boîtier (100) transfère automatiquement sur le serveur (400) les données 2100, 2200 et/ou 2300 qu'il vient d'acquérir. En retour, le boîtier (100) peut éventuellement recevoir du serveur le productible électrique du plan P qu'il vient de caractériser.

Sous-étape 4200

Pour l'exécution de cette étape 4100 dans la forme F1 de mise en oeuvre, le boîtier (100) est connecté à un ordinateur équipé d'un pilote spécifique au boîtier (100). La connexion se fait par exemple avec un câble via le port de communication (153) (type Série ou USB) ou sans câble (type WIFI ou Bluetooth). L'ordinateur connecté lance une procédure automatique de transfert des données du boîtier (100) vers le serveur (400) de traitement et de calcul.

Sous-étape 4300

Il est préférable que toute connexion au serveur passe par une procédure d'identification, de vérification et de sécurisation du transfert des données. L'identification peut être automatique ou manuelle. Elle est automatique lorsque le boîtier (100) peut transmettre son numéro de série au serveur (400) directement (4100) ou par l'intermédiaire d'un ordinateur (4200). Lorsque ce n'est pas le cas, l'identification est manuelle: l'opérateur rentre alors un mot de passe.

Etape 5000 : Traitement des données et calculs par le serveur (400)

Sous-étape 5100

De préférence, dans cette sous-étape 5100, les données brutes sont traitées par une procédure qui vérifie l'orientation et l'inclinaison du plan P (5110), vérifie ou détermine l'altitude de la localisation (5120), combine les photographies "*fish-eye"* pour produire une image précise de l'environnement de P sans zones surexposées ou sous-exposées (5130), aligne au besoin la ou les photographies par rapport au nord (5135), détermine, à partir de l'image issue de 5130, le contour des masques imposés par l'environnement au plan P (5140) puis calcule le facteur (5150) de transmission desdits masques, ainsi que le facteur (5160) de réflexion desdits masques et du sol, le contour des masques de P est utilisé pour déterminer l'influence des masques (5170) sur le rayonnement provenant de la voûte céleste.

⇒ Phase 5110 :

Suivant une première modalité remarquable 5111 de l'invention s'agissant du traitement des données, le serveur (400) peut effectuer une correction de l'orientation du plan P par rapport au nord magnétique déterminé en 2200 par le boîtier (100). Pour ce faire, le serveur (400) ajoute l'écart entre le nord géographique et le nord magnétique déterminé pour la localisation de P acquise en 2100. Cet écart est obtenu de manière connue et appropriée en soi à partir d'une base de données ou à partir d'une formule théorique classique.

Suivant une deuxième modalité remarquable 5112 de l'invention s'agissant du traitement des données, le serveur (400) peut mettre en oeuvre une procédure pour vérifier l'orientation de P et son inclinaison relativement à la position du soleil dans la série de photographies. Cette procédure est préférablement mise en oeuvre dans le cas où la (ou les) photographie(s) correspondant au temps d'exposition le plus court comporte une zone beaucoup plus lumineuse que les autres, voire saturée, zone révélatrice de la présence du soleil. L'inclinaison de P et son orientation sont utilisées pour déterminer la position du soleil à partir de la position du centre de cette zone dans la photographie. Celle-ci est ensuite comparée à la position théorique du soleil au temps t de la série de photographies, pour la localisation de P acquise en 2100. Si la distance angulaire entre la position théorique du soleil et celle déterminée à partir de la (les) photographie (s) dépasse l'incertitude due aux systèmes de mesure, l'opérateur est averti que les données acquises par le boîtier (100) au temps t sont douteuses.

⇒ Phase 5120 :

Avantageusement, le boitier (100) détermine en 2100 la latitude et la longitude et éventuellement l'altitude pour la localisation de P. En complément ou en remplacement à l'éventuelle détermination de l'altitude faite en 2100, le serveur (400) peut déterminer ou confirmer cette altitude en 2100 en mettant en oeuvre au moins l'une des procédures suivantes:

→ le serveur (400) peut utiliser la latitude et la longitude obtenue en 2100 pour déterminer l'altitude de P à partir d'une base de données topographiques ayant par exemple une résolution spatiale inférieure au km;
→ l'altitude pourrait également être déterminée ou confirmée à partir de l'adresse du site avec croisement d'informations en provenance d'un logiciel de cartographie (type Google Earth™ ou Géoportail™);
→ l'altitude pourrait également être déterminée ou confirmée en recourant à une base de données altimétrique, telle que celle issue des missions SRTM (Shuttle Radar Topography Mission) de la navette spatiale américaine, et en la déduisant des coordonnées du site.

Dans le cas où le boîtier (100) fournit également l'altitude de P, le serveur (400) compare les deux valeurs, si l'écart est important l'opérateur est averti que les données acquises par le boîtier (100) sont douteuses.
Outre les phases 5110 & 5120, la sous-étape 5100 comprend au moins l'une des phases suivantes qui correspondent chacune à une modalité avantageuse mais non limitative du procédé selon l'invention:

- phase 5130 : le serveur (400) combine la série de photographies *"fish-eye"* prises par le boîtier (100) à l'instant t pour construire une image en luminances HDR (High Dynamic Range) de l'environnement de P, cette image étant de préférence obtenue à partir des résultats de l'étalonnage en luminance de l'appareil photo numérique ou de la caméra "*fish-eye*" utilisé, en choisissant avantageusement une relation mathématique de type logarithmique entre la valeur d'un pixel de l'image HDR et la luminance du point de l'environnement de P représenté par ce pixel; l'algorithme du serveur (400) effectuant la combinaison analysant successivement chaque photographie pour ajouter à l'image HDR, la luminance des pixels exposés correctement, c'est-à-dire ceux dont la valeur de luminance est préférablement comprise entre 1% et 99%, plus préférablement encore entre 10% et 90% de la valeur maximale possible;
- phase 5135 : si l'axe x du repère (x,y,z) -cf. fig 1- n'est pas aligné sur la projection de $\vec{B}$ dans le plan (x,y) du repère (x,y,z), le serveur (400) fait tourner la photo autour de son centre d'un angle correspondant à l'angle entre l'axe x et la projection de $\vec{B}$ dans le plan (x,y);
- phase 5140 : le serveur (400) détermine le contour des masques de P à partir de l'image HDR de l'environnement obtenue en 5130;

o en décomposant l'image en deux parties : l'une appartenant au sol et située en dessous de la ligne d'horizon (LH) du site comprenant P, l'autre réputée appartenir au ciel et située au dessus de la ligne d'horizon du site comprenant P (Cf. Figure 2);
o en repérant toute variation abrupte de luminance au sein de la zone ciel, le caractère abrupt d'une variation de luminance dans la zone ciel correspondant de préférence à une variation d'au moins 1000%;
o en vectorisant le contour de chaque masque stocké ensuite dans le tableau de description des masques (TDM);

- phase 5150 : éventuellement le serveur (400) analyse les pixels de l'image HDR appartenant à chacun des masques de P (5140) pour obtenir à partir des écarts de valeur rencontrés, des informations sur le degré d'opacité de chacun des masques, c'est-à-dire son facteur de transmission (TRAM), voire sa nature (NATM) ;
- phase 5160 : le serveur (400) utilise les valeurs des pixels de l'image HDR pour déterminer le facteur de réflexion des masques (REFM) et du sol (REFS) donné par le rapport entre la valeur moyenne des luminances appartenant au masque ou au sol et la valeur moyenne des luminances appartenant à la voûte céleste, REFM & REFS étant alors également stockés dans TDM ;
- phase 5170 : les masques ayant une influence sur la transmission et la réflexion du rayonnement solaire diffus provenant de toute la voûte céleste, le serveur (400) calcule l'éclairement énergétique diffus sur le plan P en intégrant l'énergie provenant de différentes zones de la voûte céleste, de préférence au moins une cinquantaine, et, plus préférentiellement encore, au moins une centaine de zones couvrant de préférence la même portion d'espace (le même angle solide), chaque zone

o étant avantageusement une zone de forme trapézoïdale décrite par ses angles d'azimut et de zénith inférieurs et supérieurs stockés dans un tableau de description des zones du ciel (TDZC), et

o ayant par ailleurs son facteur de transmission (TRAZC) et son facteur de réflexion (REFZC) également stockés dans le TDZC,

TRAZC étant par défaut égal à 1 (en l'absence de masque, la zone transmet l'intégralité du rayonnement solaire provenant de cette direction de la voûte céleste)

REFZC étant par défaut égal à 0 (en l'absence de masque, le ciel ne réfléchit pas de rayonnement diffus);

l'algorithme du serveur (400) pour le calcul de l'éclairement énergétique diffus sur le plan P :

o détermine, à partir du tableau de description des masques TDM, les zones affectées par chacun des masques et pour chacune d'entre elles le pourcentage de surface de la zone obstruée par le masque,

o calcule pour chacune des zones affectées par un masque, le facteur de transmission (TRAZC) par pondération surfacique entre le facteur de transmission du masque (TRAM, surface de la zone occupée par le masque) et le facteur de transmission de référence égal à 1.0 (surface de la zone non occupée par le masque).

On détaille ci-après les phases 5130 à 5170 définies supra.

⇒ Phase 5130 :

La relation mathématique de type logarithmique entre la valeur (V) d'un pixel de l'image HDR et la luminance du point de l'environnement de P représenté par ce pixel, dépend entre autres du temps d'exposition (te) utilisé pour prendre la photographie. En pratique cette relation peut être e.g. $V = A(te) \log L + B(te)$

⇒ Phase 5140 (on se référera dans la description de cette phase à la figure 2 annexée):

Au sens de l'invention, un "masque" est par exemple tout obstacle susceptible de cacher une partie de la voûte céleste, qu'elle soit traversée ou non par le soleil So (voir figure 2), au cours de l'année. L'objectif, de préférence "*fisheye*", utilisé par le boîtier (100) produit une image circulaire couvrant l'intégralité de l'environnement vu par le plan P (voir figure 2). Les masques M1 & M2 apparaissent sur la Figure 2. Lorsque le plan P est incliné, il voit non seulement la voûte céleste VC et les masques M1 & M2, mais aussi le sol Gn. La partie de sol vue par P se situe entre le bord du cercle de projection CP (pourtour de l'image) et la ligne d'horizon théorique LH du lieu. Cette ligne LH est assimilable à un arc d'ellipse déterminé par exemple mathématiquement à partir de la latitude et de l'altitude du lieu ainsi que de la position angulaire de la (des) photographie(s) connue grâce à α (inclinaison de P-cf. fig 1- étape 2010) et β (orientation de P-cf. fig 1- étape 2020) (l'inclinaison de P). Dans la partie de l'image située immédiatement au dessus de la ligne d'horizon, les masques se trouvent entre la ligne d'horizon LH et le zénith Zn; en l'occurrence cela correspond au masque M2 sur la figure 2. Dans la partie qui est au-delà du zénith Zn et qui n'a pas de ligne d'horizon, les masques se trouvent entre le bord du cercle de projection CP et la voûte céleste VC (M 1 sur la figure 1). Le contour d'un masque est déterminé par le lieu des variations abruptes de luminance du bord du cercle ou de la ligne d'horizon vers le centre de l'image. Le contour de chaque masque M1 & M2 est vectorisé puis stocké dans le tableau de description des masques (TDM).

⇒ Phase 5150 :

L'algorithme utilisé pour délimiter chaque masque (5150) peut aussi fournir des informations sur leur granularité, ceci à partir des différences entre les valeurs des pixels appartenant au masque. Cette information peut ensuite être utilisée pour déterminer l'opacité du masque, c'est-à-dire son facteur de transmission (TRAM), mais aussi sa nature (NATM). Un arbre présentera généralement une certaine granularité, plus celle-ci sera élevée, plus l'arbre transmettra une fraction importante du rayonnement solaire. La nature et le facteur de transmission de chacun des masques peuvent donc également être stockés dans le tableau de description des masques.

⇒ Phase 5160 :

Les valeurs des pixels de l'image HDR sont utilisées pour déterminer le facteur de réflexion des masques et du sol. Dans une première approche, le facteur de réflexion d'un masque ou du sol est le rapport entre la valeur moyenne des luminances appartenant au masque ou au sol et la valeur moyenne des luminances appartenant à la voûte céleste. Le facteur de réflexion de chacun des masques (REFM) est alors également stocké dans le tableau de description des masques. Le facteur de réflexion du sol est noté REFS.

⇒ Phase 5170 :

Les masques ont une influence sur la transmission et la réflexion du rayonnement solaire diffus provenant de toute la voûte céleste. Le serveur calcule l'éclairement énergétique diffus sur le plan P en intégrant l'énergie provenant de différentes zones du ciel (ZC). Pour cela, la voûte céleste est divisée en au moins une cinquantaine et préférentiellement une centaine de zones couvrant la même portion d'espace (le même angle solide). Chaque zone de ciel, de préférence trapézoïdale, est décrite par ses angles d'azimut et de zénith inférieurs et supérieurs stockés dans le tableau de description des zones du ciel (TDZC). Chaque zone a son facteur de transmission (TRAZC) et son facteur de réflexion (REFZC) également stockés dans le TDZC. Par défaut, TRAZC est égal à 1 (en l'absence de masque, la zone transmet l'intégralité du rayonnement solaire provenant de cette direction de la voûte céleste). Par défaut, REFZC est égal à 0 (en l'absence de masque, le ciel ne réfléchit pas de rayonnement diffus). A partir du tableau de description des masques TDM, un algorithme détermine les zones affectées par chacun des masques et pour chacune d'entre elles le pourcentage de surface de la zone obstruée par le masque. Pour chacune des zones affectées par un masque, on calcule le facteur de transmission (TRAZC) par pondération surfacique entre le facteur de transmission du masque (TRAM, surface de la zone occupée par le masque) et le facteur de transmission de référence égal à 1.0 (surface de la zone non occupée par le masque). On calcule également le facteur de réflexion (REFZC) par pondération surfacique entre le facteur de réflexion du masque (REFM, surface de la zone occupée par le masque) et le facteur de réflexion de référence égal à 0.0 (surface de la zone non occupée par le masque).

Sous-étape 5200

Cette sous-étape 5200 consiste donc essentiellement en une saisie par l'opérateur et en la transmission au serveur (400), d'une part, de paramètres choisis dans le groupe comportant: l'identification de l'utilisateur, création de projet, gestion de projets en cours......, et, d'autre part, de paramètres nécessaires aux calculs. La sous-étape 5200 comprend au moins l'une des phases 5210, 5220 & 5230 suivantes qui correspondent chacune à une modalité avantageuse mais non limitative du procédé selon l'invention:

⇒ Phase 5210 :

Les informations résultant du traitement des données du boîtier (100) sont résumées dans une fiche projet créée par le serveur dans l'espace privé de l'utilisateur. Cette fiche peut être consultée à tout moment par l'utilisateur. Elle présente la localisation du plan P, son orientation et son inclinaison enfin les résultats de l'analyse des masques. Le contour de chaque masque, sa nature et son facteur de réflexion REFM sont présentés en superposition à l'image HDR. L'opérateur peut éventuellement modifier le contour des masques au moyen d'un outil d'édition permettant l'ajout, le déplacement, la suppression de points... Les modifications validées par l'opérateur sont prises en compte par le serveur (400) qui génère ensuite une nouvelle fiche projet.

⇒ Phase 5220 :

Pour pouvoir calculer le potentiel de production électrique de P (productible), il est intéressant, conformément à l'invention, que le serveur (400) utilise des informations concernant la chaîne de transformation de l'énergie solaire en énergie électrique (conversion électrique) qui comprend le(s) panneaux photovoltaïque(s), au moins un onduleur et du câblage. Ces informations sont e.g. des caractéristiques des panneaux photovoltaïques, des câbles électriques et des onduleurs. Les panneaux sont notamment caractérisés par le facteur de transmission du matériau (généralement du verre) disposé entre l'extérieur et les cellules (capteur) sensibles e.g. en silicium, par leur structure [intégrée (encastrée) ou non -superstructure- au support (e.g. le toit)] et par leur rendement électrique.

⇒ Phase 5230 :

Le serveur (400) propose à l'opérateur des valeurs par défaut qu'il peut modifier. Les valeurs par défaut proviennent des informations rentrées par l'opérateur dans le dernier projet qu'il a étudié. Si l'opérateur souhaite rentrer de nouvelles valeurs, le serveur peut mettre par exemple à sa disposition une base de données des caractéristiques de panneaux et d'onduleurs proposés par les fabricants.

Sous-étape 5300

Suivant une modalité avantageuse de l'invention, il est prévu notamment que dans la sous-étape 5300, le serveur (400) extrait des données microclimatiques :

- choisies dans le groupe comprenant au moins l'une des données suivantes:

  l'éclairement énergétique direct sur un plan perpendiculaire à la direction du soleil (ENS), l'éclairement énergétique diffus sur un plan horizontal (EHD) et la température de l'air extérieur (TAE);

- et issues d'une base de données :

  o dont la résolution spatiale correspond à une couverture géographique inférieure ou égale à 100 km, de préférence à 10 km, pour prendre en compte les variations microclimatiques
  o et dont la résolution temporelle correspond à un pas de temps Pt inférieur ou égal à à l'heure, de préférence à la demi-heure, pour prendre en compte la dynamique des variations du rayonnement solaire, pour chaque jour J, sur une période Pe d'au moins cinq ans, de préférence d'au moins 10 ans.

Pour calculer le potentiel de production électrique de P (productible), il est avantageux, conformément à l'invention, que le serveur (400) utilise des données décrivant le plus précisément possible le climat du lieu où se trouve le plan P. Le serveur fait appel à une base de données à résolution spatiale et temporelle élevée. De préférence, la résolution spatiale de cette base correspond à une couverture géographique inférieure à 10 km. Cela permet au système de prendre en compte les variations microclimatiques. La résolution temporelle des données correspond préférablement à un pas de temps Pt inférieur ou égal à l'heure voire à la demi-heure, pour permettre au système de prendre en compte la dynamique des variations du rayonnement solaire.

Pour représenter correctement les tendances climatiques du lieu considéré (localisation 2100), la base de données couvre une période Pe au moins 5 ans, voire 10 ans ou plus. Idéalement, elle est mise à jour chaque année. Le serveur (400) fait par exemple appel à une ou plusieurs bases de données offrant ces caractéristiques et couvrant l'Europe et le reste du monde. Les données comportent au minimum l'éclairement énergétique direct sur un plan perpendiculaire à la direction du soleil (ENS), l'éclairement énergétique diffus sur un plan horizontal (EHD) et la température de l'air extérieur (TAE). Elles doivent être fournies avec le pas de temps (Pt), le jour (J) et la période (Pe) auxquels elles correspondent.

L'un des atouts de l'invention est l'exploitation d'une base de données climatique particulières, de préférence d'une base de données microclimatiques, ces dernières étant notamment issues des radiomètres utilisés par les satellites géostationnaires. La précision et la fiabilité de telles données microclimatiques dépassent largement celles de stations de mesure au sol, dont la densité d'implantation est très variable selon les pays et souvent top insuffisante pour restituer les variations locales.

Avantageusement, le serveur (400) et la base de données climatiques sont accessibles via internet sur le site www.satel-light.com. Cette base de données a été développée par le LASH sous la direction scientifique du Dr. DUMORTIER, dans le cadre d'un projet européen (Satel-Light, 99) qui modélise la clarté du ciel à partir des images du canal visible du satellite géostationnaire Météosat. La base de données couvre 48 pays européens, du Maroc à la Russie, avec une résolution spatiale d'environ 5 km (latitude par 7 km) [longitude à un pas de temps (pt1) de la demi-heure]. Cinq années d'images satellites de 1995 à 2000 ont été traitées pour pouvoir établir des tendances climatologiques.

Naturellement l'invention n'est pas limitée au choix de la base de données et du serveur Satel-Light. Tous les équivalents d'un tel serveur et/ou d'une telle base qui existent ou qui existeront pourraient convenir.

Sous-étape 5400

Suivant une modalité avantageuse de l'invention, il est prévu notamment que dans la sous-étape 5400, le serveur (400) :

- effectue une boucle de calcul sur tous les instants d'un pas de temps (Pt'), des jours (J) et d'une période (Pe'), où Pe' est inférieure ou égale à la période Pe couverte par les données climatiques extraites en 5300, où le pas de temps Pt' est inférieur ou égal à Pt,
- calcule, dans le cadre de la phase 5410 de la totalité de l'énergie solaire reçue par P, et pour tous les instants de chaque pas Pt' de la boucle :

  o la position du soleil par rapport au plan P (5411),
  o de préférence, la contribution énergétique EPS du soleil sur le plan P (5412),
  o de préférence, la contribution énergétique EPC de la voûte céleste (5413),
  o de préférence, la contribution énergétique EPRM sur le plan P de la réflexion du rayonnement solaire direct sur les masques (5414),
  o de préférence, la contribution énergétique EPRS sur le plan P de la réflexion du rayonnement solaire sur le sol (5415),

o et, la contribution énergétique totale ETP sur le plan P = EPS + EPC + EPRM + EPRS,

- calcule, dans le cadre de la phase 5420 et pour tous les instants de chaque pas Pt' de la boucle, l'énergie électrique produite par la chaîne de transformation en multipliant ETP par le rendement de conversion électrique RENP du ou des panneaux solaires photovoltaïques de ladite chaîne (de préférence le rendement nominal RENPNOM à 25˚C), de préférence en déduisant les pertes générées par ladite chaîne,
- calcule, dans le cadre de la phase 5421 et pour tous les instants de chaque pas Pt' de la boucle, le RENP (de préférence le RENPNOM à 25˚C) en utilisant de préférence un modèle thermique dynamique selon lequel la température (TP) du ou des panneaux solaires photovoltaïques est déterminée à partir de ETP, la température de l'air (TAE) au pas Pt' considéré ainsi que la température des panneaux photovoltaïques au pas Pt' précédent de la boucle.

Il apparaît donc que conformément à l'invention, le potentiel de production électrique (productible) du plan P est déterminé en prenant en compte la dynamique du climat du lieu. Pour cela le serveur (400) effectue une boucle de calcul sur tous les instants d'un pas de temps (Pt'), des jours (J) et d'une période (Pe'), où Pe' est au plus égale à la période Pe couverte par les données climatiques issues de la base de données. Quand Pe' est inférieure ou égale à Pe, les années supprimées peuvent être par exemple celles correspondant à des extrema. Le pas de temps Pt' est de préférence inférieur ou égal à Pt, plus préférentiellement encore égal à Pt. Pour avoir Pt' inférieur à Pt, il est envisageable d'extrapoler des valeurs intermédiaires à partir des données au pas Pt.

5410 A chaque pas de la boucle (5400), dans lé cadre de la phase 5410, le serveur calcule la position du soleil par rapport au plan P (5411) et de préférence l'éclairement énergétique total de P (5412). Cet éclairement énergétique total de P provient du soleil (5413), de la voûte céleste (5414), des masques (5415) et du sol (5416). L'éclairement énergétique du plan P est celui reçu par les capteurs (e.g en silicium) d'un (ou des) panneaux photovoltaïques. Dans tous les calculs, le serveur (400) tient avantageusement compte du facteur de transmission du rayonnement solaire du matériau (généralement du verre) situé entre l'extérieur et les capteurs (e.g en silicium) et, notamment, de sa variation en fonction de l'angle d'incidence.

Ainsi, la phase 5410 comprend au moins l'une des sous-phases suivantes qui correspondent chacune à une modalité avantageuse mais non limitative du procédé selon l'invention:

⇒ Sous-Phase 5411 :

Le serveur (400) utilise les coordonnées de latitude et de longitude du site de P (2100) pour calculer en fonction de Pt', J et Pe', la position du soleil dans le ciel (AZIS, ZENS) et son angle d'incidence par rapport au plan P (GAMS). L'algorithme est choisi parmi ceux qui sont appropriés et connus de l'homme de l'art.

Pour sécuriser ce calcul, il est possible de mettre une contre-mesure, selon laquelle, connaissant au temps réel tr la position théorique du soleil pour la localisation 2100 de P, on vérifie si il est possible que, sur la photographie prise au temps réel tr, le point le plus brillant correspond à cette position théorique à une marge d'incertitude près.

⇒ Sous-Phase 5412 :

Le serveur (400) calcule la contribution énergétique du soleil sur le plan P. Le calcul n'est effectué que si l'éclairement énergétique du soleil est non nul à cet instant du pas de la boucle. Un algorithme utilise le tableau de description des masques TDM (5140) pour déterminer si compte tenu de sa position (5411), le soleil se trouve derrière un masque. Si le soleil est effectivement masqué, l'éclairement énergétique du soleil (ENS) est modifié notamment pour tenir compte du facteur de transmission du masque (TRAM). L'éclairement énergétique sur le plan P dû au soleil (EPS) est alors calculé selon les formules classiques du rayonnement solaire en prenant en compte de préférence, le facteur de transmission du rayonnement solaire du matériau (généralement du verre) situé entre l'extérieur et les capteurs (e.g en silicium) et, notamment, de sa variation en fonction de l'angle d'incidence.

⇒ Sous-Phase 5413 :

Le serveur (400) calcule la contribution énergétique de la voûte céleste sur le plan P. Un modèle de ciel est utilisé pour calculer la luminance énergétique (LEZC) de chacune des zones de ciel (5170) à partir de l'éclairement énergétique du soleil (ENS) et de l'éclairement horizontal diffus (EHD). L'algorithme utilisé notamment pour la mise en oeuvre de l'étape 5413 peut par exemple être basé sur les modèles de distribution de luminances du ciel notamment celui décrit par Perez dans « Modelling daylight availability and irradiance components from direct and global irradiance » publié dans la revue Solar Energy, 1990, Vol. 44, N˚5. Le modèle de ciel s'adapte à toutes les conditions nuageuses: du ciel couvert au ciel clair. La luminance de chaque zone est multipliée par le facteur de transmission de la zone (TRAZC) pour obtenir la luminance (TLEZC) effectivement transmise par la zone. Lorsqu'une zone a un facteur de réflexion non nul (elle est masquée partiellement ou en totalité), le serveur (400) calcule la luminance énergétique de la zone résultant des réflexions sur cette zone (RLEZC). Pour cela, le serveur (400) multiplie la quantité totale de lumière reçue par la zone en provenance des autres zones, par le facteur de réflexion de la zone (REFZC), puis on calcule RLEZC à partir de la loi de Lambert (formule classique en rayonnement). La luminance énergétique globale de la maille (GLEMC) est la somme de TLEMC et RLEMC. L'éclairement énergétique sur le plan P dû à la voûte céleste (EPC) est alors calculé en intégrant les GLEMC selon les formules classiques du rayonnement solaire et de préférence, le facteur de transmission du rayonnement solaire du matériau (généralement du verre) situé entre l'extérieur et les capteurs (e.g en silicium) et, plus préférentiellement encore pour chaque angle d'incidence d'une zone du ciel avec P.

$\Rightarrow$ Sous-Phase 5414 :

Le serveur (400) calcule la contribution énergétique sur le plan P de la réflexion du rayonnement solaire direct sur les masques. Le calcul n'est effectué que si l'éclairement énergétique du soleil est non nul à cet instant du pas de la boucle. Un algorithme utilise le tableau de description des masques TDM (5140) ainsi que la position du soleil (5411), pour déterminer l'angle d'incidence du soleil sur le masque. Cet angle d'incidence est utilisé pour déterminer l'éclairement énergétique reçu par le masque de la part du soleil. Si cet éclairement n'est pas nul, l'algorithme calcule la luminance énergétique du masque LEMR en supposant que celui-ci réfléchit le rayonnement solaire de manière diffuse (loi de Lambert) avec un facteur de réflexion égal à REFM. L'éclairement énergétique sur le plan P dû à la réflexion du rayonnement solaire direct sur les masques (EPRM) est alors calculé en intégrant les LEMR selon les formules classiques du rayonnement solaire. Le calcul tient compte, de préférence, du facteur de transmission du rayonnement solaire du matériau (généralement du verre), situé entre l'extérieur et les capteurs (e.g en silicium) et, plus préférentiellement encore pour chaque angle d'incidence entre un masque et P.

$\Rightarrow$ Sous-Phase 5415 :

Le serveur (400) calcule la contribution énergétique sur le plan P de la réflexion du rayonnement solaire total sur le sol supposé horizontal. L'algorithme calcule la luminance énergétique du sol LESR en supposant que celui-ci réfléchit le rayonnement solaire de manière diffuse (loi de Lambert) avec un facteur de réflexion égal à REFS. L'éclairement énergétique sur le plan P dû à la réflexion du rayonnement solaire total sur le sol (EPRS) est alors calculé à partir de LESR selon la formule classique du rayonnement solaire. Il est tenu compte, de préférence, du facteur de transmission du rayonnement solaire du matériau (généralement du verre) situé entre l'extérieur et les capteurs (e.g en silicium) et, plus préférentiellement encore pour chaque angle d'incidence moyen entre le sol et P.

$\Rightarrow$ Sous-Phase 5416 :

Le serveur (400) calcule la contribution énergétique totale sur le plan P (ETP) après traversée du matériau (généralement du verre) situé entre l'extérieur et les capteurs (e.g en silicium). C'est la somme des contributions énergétiques EPS (5412), EPC (5413), EPRM (5414) et EPRS (5415).

5420 A chaque pas de la boucle (5400), dans le cadre de la phase 5420, le serveur calcule le serveur calcule le rendement de la chaîne de conversion électrique. Il calcule la température des panneaux photovoltaïques pour déduire la puissance électrique délivrée par les capteurs e.g. en silicium du ou des panneaux (5421) puis les pertes associées à la chaîne de transformation électrique (5422).

Ainsi, la phase 5420 comprend au moins l'une des sous-phases suivantes qui correspondent chacune à une modalité avantageuse mais non limitative du procédé selon l'invention:

$\Rightarrow$ Sous-Phase 5421 :

Le serveur utilise un modèle thermique dynamique pour calculer à l'instant t du pas de la boucle, la température des panneaux photovoltaïques TP(t) de l'installation en prenant en compte l'éclairement énergétique total de P ETP(t), la température de l'air TA(t) à cet instant, ainsi que la température des panneaux photovoltaïques au pas précédent de la boucle TP(t-1). Le modèle prend de préférence en compte la structure du ou des panneaux. Le serveur calcule le rendement électrique RENP(t) du ou des panneaux à partir de TP(t) et des caractéristiques des cellules comprises dans le ou les panneaux solaires photovoltaïques, à savoir de préférence notamment le rendement nominal RENPNOM à 25˚C. La puissance électrique délivrée par le panneau est alors obtenue en multipliant le rendement par l'éclairement énergétique total de P, à savoir ETP(t).

Le modèle retenu selon l'invention est par exemple le modèle physique décrit par Jones dans « a thermal model for photovoltaic systems » publié dans la revue Solar Energy 70, N˚4, 2001, ou le modèle empirique développé par Sandia National Laboratories et décrit par D.L. King dans « Photovoltaic Array Performance Model » en Septembre 2003.

En pratique, la structure du ou des panneaux photovoltaïques, c'est-à-dire par exemple le fait que le ou les panneaux photovoltaïques soi(en)t encastré(s) plutôt qu'en champ libre (super-structure), intervient sur TP(t)en réduisant les échanges convectifs sur la surface arrière des panneaux.

⇒ Sous-Phase 5422 :

Les pertes occasionnées par chaque élément de la chaîne de transformation de l'énergie solaire en énergie électrique sont avantageusement prises en compte de manière forfaitaire, à savoir par exemple respectivement les pertes occasionnées par les câbles pour une valeur de V1%, les pertes occasionnées par l'onduleur sont prises en compte à partir du rendement de transformation lié au type d'onduleur choisi (5200) pour une valeur de V2%. La puissance électrique délivrée par le panneau (5421) est alors diminuée successivement des deux facteurs V1 et V2.

Etape 6000 : Edition des résultats par le serveur (400)

Avantageusement, le serveur (400) édite tout ou partie des résultats du potentiel de production électrique de P (productible) calculé. Cette édition peut se faire par exemple sous la forme de rapports présentant sous forme graphique et textuelle, entre autres, l'énergie solaire incidente moyenne mensuelle, le productible électrique, le temps de retour sur investissement. Ces rapports mettent en évidence les grandes tendances des variations annuelles du productible électrique. Ils peuvent également tenir compte du vieillissement de l'installation.

De préférence, le serveur (400) est susceptible d'être connecté à internet et comprend au moins le serveur (400) est constitué par au moins un système informatique délocalisé sur un site internet et/ou par au moins un ordinateur personnel (PC) situé sur un site de l'opérateur.

Le procédé selon l'invention permet ainsi d'effectuer plusieurs séries de mesure de terrain, étapes 1000, 2000 et éventuellement 3000 pour différents sites (Cp). Les données collectées étant avantageusement stockées dans une mémoire, il est possible de réaliser, pour les différents Cp considérés, la connexion et l'acquisition des données climatiques, ainsi que les calculs du potentiel énergétique de ces différents Cp, à un moment ultérieur (Etapes 4000 à 6000). Ces étapes peuvent ainsi être réalisées par le serveur via uniquement le boîtier (100) et/ou sur un ordinateur d'utilisation [ordinateur personnel (PC)] situé sur un site de l'opérateur permettant la connexion et la transmission des données au serveur (400) et à la base de données microclimatiques 5300 notamment.

Ce processus séquentiel est particulièrement adapté pour les installateurs de systèmes photovoltaïques, qui peuvent réaliser les mesures sur les différents sites et procéder à la connexion, au calcul et à l'édition des résultats, en une seule séquence sur l'ordinateur d'utilisation au terme de la séquence de mesure.

**Le dispositif selon l'invention**

Il existe de nombreux serveurs susceptibles de convenir à l'invention. Bon nombre de ces serveurs, sont accessibles via Internet par abonnement.

L'ordinateur d'utilisation facultatif (PC) est un matériel classique, fixe ou portable, dont sont équipées désormais la plupart des entreprises, et en particulier, les utilisateurs potentiels que sont les installateurs de systèmes photovoltaïques.

De préférence, le boîtier (100) contient au moins un module (101) délimité par une coque et comprenant au moins une surface plane (102), par exemple la face inférieure dudit module (101) -de la coque-, cette surface plane (102) étant utile comme référentiel et destinée à être disposée dans le plan P ou dans un plan parallèle à P. Par ailleurs, tout ou partie des moyens (110) à (150) sont disposés dans ce module (101) de préférence parallèlement à cette surface plane (102), la face externe (face d'appui) de la semelle (190) du boîtier (100) étant de préférence équipée de moyens antidérapants constitués par un revêtement, par exemple en caoutchouc ou en silicone.

Avantageusement, ce boîtier (100) est conçu pour être déposé sur la surface du site (e.g. d'un toit) comprenant le plan P et pour s'auto-positionner sur ladite surface de telle sorte que la surface plane (102) utile comme référentiel soit dans le plan P.

Ainsi, le boîtier (100) peut être plus commodément disposé sur tout type de surface, en particulier sur des surfaces en hauteur inclinées ou non, par exemple sur des toits.

Dans la mesure où certaines surfaces destinées à comprendre un champ photovoltaïque Cp, peuvent avoir un relief irrégulier, comme c'est le cas par exemple des toits revêtus de tuiles ou d'autres toitures irrégulières, il est préférable et avantageux que la face externe du fond (face d'appui) du boitier (100) ait une surface suffisante pour s'affranchir des irrégularités de surface du site (e.g. un toit) comprenant le plan P et pour permettre à la surface plane (102) utile comme référentiel, de coïncider avec P ou avec un plan parallèle à P.

En d'autres termes, il est avantageux selon l'invention que la plus petite dimension D du boîtier (100) soit suffisamment élevée pour que le boîtier (100), une fois posé sur la surface (e.g. un toit) comprenant le plan P, soit dans un plan contenant les sommets des irrégularités [de préférence D supérieure ou égale à la plus petite distance entre deux sommets successifs des irrégularités de la surface (e.g. du toit)] et pour permettre à la semelle (190) du boîtier (100) de coïncider avec P ou avec un plan parallèle à P. Quand il s'agit de surfaces ondulées caractérisées par une longueur d'onde λ (distance entre deux crêtes ou sommets). La plus petite dimension D du boîtier (100) est supérieure ou égale à 2*λ

Par exemple pentagonale (en papillon comme c'est le cas dans les figures illustratives 3 à 7 annexées). Suivant un mode de réalisation du boîtier (100), celui-ci a une forme générale polygonale (e.g. en vue de face) voire en trapèze ou en triangle.

Pour permettre la dépose du boîtier à l'aide d'un outil, le boîtier (100) comporte avantageusement au moins un moyen de préhension, de préférence au moins une longe (170), localisé sur le côté le plus proche du centre de gravité G du boîtier (100).

Pour protéger le boitier (100) en cas de chute notamment les éléments sensibles de celui-ci, ledit boîtier (100) comporte de préférence au moins une enveloppe en matériau absorbant (180) (e.g. mousse de polyéthylène) disposée autour du module (101) comprenant tout ou partie des éléments (110) à (150)

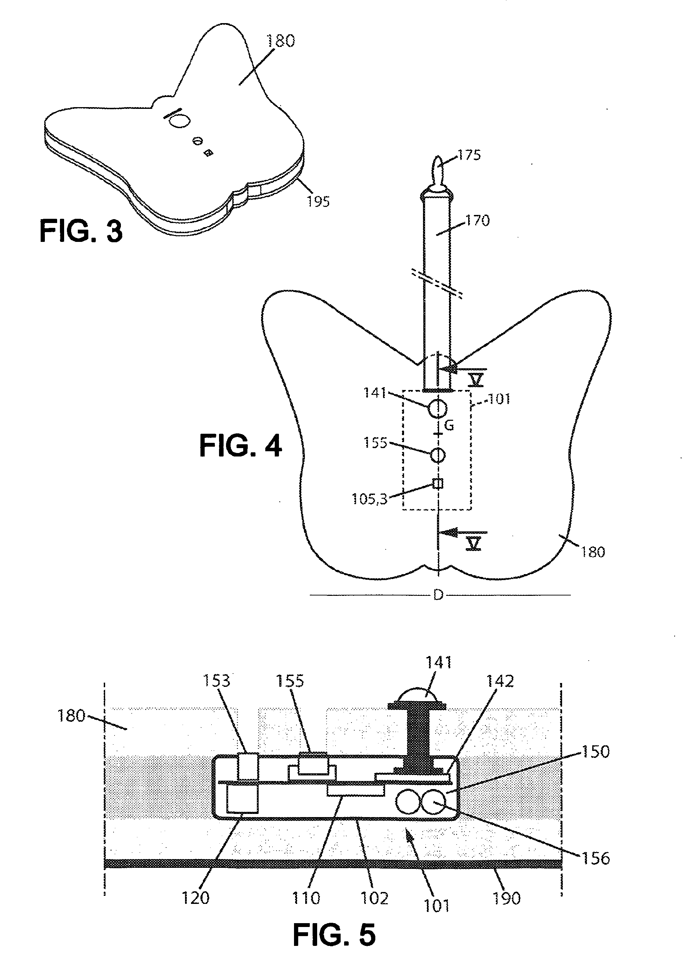

L'exemple de réalisation montré aux figures 3, 4 et 5 du dessin annexé, concerne un boîtier d'acquisition 100, de forme générale analogue à celle d'un papillon.

Comme cela ressort des figures 3 et 4, le boîtier d'acquisition 100 dont le centre de gravité est désigné par G, comporte un moyen de préhension (170) constitué par une longe terminée par un crochet (175).

La figure 5 fait apparaître la semelle (190), et la surface plane (102) utile comme référentiel et destiné à être disposée dans le plan P ou dans un plan parallèle à P. Sur cette semelle, sont fixés un capteur CCD (142) qui constitue avec l'objectif "*fish-eve*" (141), l'appareil de photographie numérique (140), une carte électronique (150) équipée d'une mémoire de stockage 151 et d'un processeur de calcul (152) (tout deux non représentés sur la figure 5), d'un port de connexion et d'identification (153) et de deux inclinomètres (120). Le système de géopositionnement satellitaire (110), de même que la boussole (130) (non représentée sur la figure 5), sont des éléments également inclus dans la carte électronique (150).

#### L'installation selon l'invention

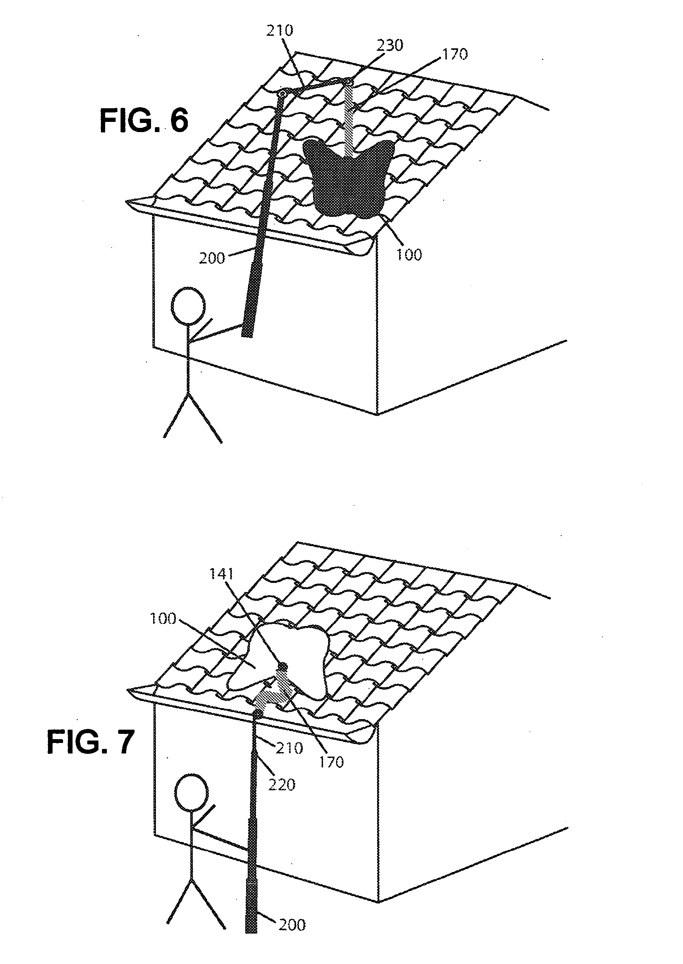

Les figures 6 et 7 illustrent cette installation et son utilisation.

Cette installation comprend le boîtier (100) et au moins une perche (200), de préférence télescopique destinée à coopérer avec ledit boîtier (100) pour assurer, sans recourir à une échelle, la dépose de celui-ci sur la surface du site (par exemple un toit) destiné à recevoir le champ photovoltaïque Cp, ledit champ Cp comprenant le plan P.

Le boîtier (100) est tel que défini ci-dessus. La perche télescopique (200) peut être articulée. Ainsi, dans l'exemple, son extrémité supérieure (210) est un segment articulé dont l'extrémité libre comprend par exemple un anneau (230) apte à coopérer avec le crochet (175) de la longe (170).

Les figures 6 et 7 montrent que l'utilisateur peut suspendre le boîtier (100) à l'extrémité de la perche articulée 200 par l'intermédiaire de la longe 170. Le centre de gravité G du boîtier (100) et le moyen de préhension coopérant avec la longe 170 sont disposés de telle sorte qu'en position suspendue, le sommet du boîtier (100) opposé au côté le plus proche de G, pointe vers le bas. L'opérateur présente le boîtier (100) ainsi suspendu sur la surface du toit destiné à recevoir Cp. Le sommet du boîtier (100) opposé au côté le plus proche de G, prend appui sur le toit quand l'opérateur manoeuvre la perche 200 vers le bas. Le boîtier (100) prenant appui vient se poser délicatement sur le toit. La semelle 190 du fond du boîtier (100) (face d'appui), a une surface et des dimensions suffisantes (plus petite dimension D) pour que le boîtier (100) repose à plat sur le plan P du toit. La surface de référence (102) du boîtier (100) est parallèle à P, malgré les irrégularités de relief du toit. Le boîtier (100) est maintenu de manière stable sur le pan incliné du toit au moyen du revêtement anti-adhérent qui constitue la semelle (190).

L'acquisition des données selon l'étape 2000 peut être effectuée dès lors que le boîtier (100) est immobile et à plat sur le toit, sachant que l'opérateur a pris soin d'actionner le bouton -poussoir (155) avant d'effecteur la dépose du boîtier (100) sur le toit.

La répartition des masses de l'appareil et la position caractéristique de la sortie de la longe 170 sur le dessus du boîtier 100 mais en deçà du centre de gravité, garantissant de poser à plat la semelle (190) du boîtier (100) dans le plan P en reculant la perche (200) jusqu'à la fixer sur le rebord du plan P (cf. fig 7). Cette fonction permet la mise en oeuvre du système par un seul opérateur sans prise de risques superflus dans la phase de pré-diagnostic.

#### Revendications

**1.** Procédé d'évaluation du potentiel de production électrique d'un plan P d'inclinaison et d'orientation quelconques,

et comprenant ou destiné à comprendre au moins un panneau solaire photovoltaïque, ledit panneau étant inclus dans une chaîne de transformation de l'énergie solaire en énergie électrique qui comprend également au moins un onduleur et du câblage, **caractérisé en ce qu'**il consiste essentiellement :

1000 à mettre en oeuvre au moins un boîtier (100) intelligent de caractérisation automatique de P et de l'environnement dudit plan P, ce boîtier (100) étant posé dans le plan P ;

2000 à lancer au moyen du boîtier (100) un processus d'acquisition des données suivantes :

2100 localisation de P par sa latitude et sa longitude et, de préférence son altitude ;

2200 orientation et inclinaison de P ;

2300 capture optique de la composition de l'environnement tel qu'il est vu du plan P de préférence photographies panoramiques;

2400 date et heure de l'acquisition ;

3000 éventuellement à stocker tout ou partie des données 2100, 2200, 2300, 2400 acquises à l'étape 2000, en vue d'un transfert ultérieur sur un serveur 400 de traitement dédié ;

4000 à transférer les données 2100, 2200, 2300, 2400 acquises à l'étape 2000 sur le serveur 400 de traitement dédié ;

5000 à traiter des données, notamment les données 2100, 2200, 2300, 2400 acquises à l'étape 2000, au moyen du serveur 400 de traitement dédié, pour calculer le potentiel de production électrique de P, ce traitement de données comprenant les sous-étapes suivantes :

5100 traitement des données 2100, 2200, 2300, 2400 acquises à l'étape 2000 et transmises à l'étape 4000, pour localiser et déterminer l'influence des obstacles sur les rayonnements solaires direct et diffus auxquels est éventuellement exposé le plan P, ces obstacles situés dans l'environnement de P étant décrits par leur aptitude à réfléchir, transmettre ou bloquer le rayonnement solaire direct ou diffus;

5200 échange d'informations entre un opérateur et le serveur ;

5300 extraction de données microclimatiques comprenant l'énergie solaire directe et diffuse et éventuellement la température de l'air, pour la localisation 2100 de P, et ce à un pas de temps Pt inférieur ou égal à 24 heures, de préférence inférieur ou égal à 1 heure et pour une période Pe d'au moins une année pleine ;

5400 calcul itératif et dynamique du potentiel de production électrique de P, à un pas de temps Pt' inférieur ou égal à 24 heures, de préférence inférieur ou égal à 1 heure, et plus préférentiellement encore inférieur ou égal à 30 minutes et pour une période Pe' d'au moins une année pleine, de préférence Pt' & Pe' étant respectivement et indépendamment égaux à Pt & Pe, par mise en oeuvre des phases suivantes :

5410 calcul de la totalité de l'énergie solaire reçue par P en tenant compte de l'influence des obstacles localisés en 5100 et du sol sur les rayonnements solaires direct et diffus ;

5420 calcul de l'énergie électrique produite par la chaîne de transformation, à partir de l'énergie solaire calculée en 5410 en tenant compte :

5421 du rendement du -ou des- panneau-x-, en intégrant éventuellement dans ce rendement la température de surface du -ou des- panneau-x-obtenue à partir de la température extraite éventuellement en 5300 ;

5422 et éventuellement des pertes supplémentaires dues à -aux- onduleur-set au câblage ;

6000 à éditer les résultats des calculs sous forme de rapport-s-, de préférence transmis au boîtier (100), et/ou présentés sur l'écran du serveur et/ou imprimés.

**2.** Procédé selon la revendication 1, **caractérisé en ce que** l'étape 1000 consiste à poser le boîtier (100) sur le plan P, au moyen d'au moins un outil, de préférence une perche, de dépose du boitier 100 sur le plan P.

**3.** Procédé selon la revendication 1 ou 2, **caractérisé en ce que** l'étape 2000 d'acquisition des données consiste essentiellement à :

2100 déterminer la longitude, la latitude et éventuellement l'altitude de P au moyen d'un système de Géo-Positionnement Satellitaire GPS.

2200 déterminer :

→ 2210 : d'une part, l'inclinaison de P par rapport à la verticale du lieu au travers de l'angle par rapport à l'horizontale [pente α 2210] de son vecteur de plus grande pente, de préférence au moyen d'au moins deux inclinomètres électroniques, et, plus préférentiellement encore au moyen d'au moins trois accéléromètres perpendiculaires entre eux, formant un trièdre (x, y, z), dont deux des axes (x, y) sont dans le plan de référence P et permettant la mesure des 3 composantes ($g_x$, $g_y$, $g_z$) du vecteur gravitationnel $\vec{g}$, qui définit la verticale du lieu et dont la projection $\vec{g}_P$, = ($g_x$, $g_y$, 0) dans le plan P, donne le vecteur de plus grande pente, la pente α entre $\vec{g}$ et $\vec{g}_P$ étant donnée par

$$\cos(\alpha) = \frac{\sqrt{g_x^2 + g_y^2}}{\sqrt{g_x^2 + g_y^2 + g_z^2}}$$

→ 2220 : et, d'autre part, l'orientation de P au travers de son azimut β 2220 de préférence l'azimut P de son vecteur de plus grande pente par rapport au nord (avantageusement le nord magnétique), au moyen d'une boussole, de préférence une boussole constituée par un système de mesure du champ magnétique terrestre comprenant au moins trois capteurs magnétiques perpendiculaires entre eux formant un trièdre (x', y', z'), de préférence identique au trièdre (x, y, z), dont deux axes (x, y) sont dans le plan de référence P et permettant de mesurer les coordonnées ($B_x$, $B_y$, $B_z$) du vecteur du champ magnétique terrestre $\vec{B}$ dans le repère (x, y, z) ;
le boîtier (100) intelligent définissant ensuite :

- un vecteur $\vec{A}$ perpendiculaire à $\vec{B}$ et $\vec{g}$ :

$$\vec{A} = \vec{B} \wedge \vec{g} = \begin{pmatrix} B_y g_z - g_y B_z \\ -B_x g_z + g_x B_z \\ B_x g_y - g_x B_y \end{pmatrix} = \begin{pmatrix} A_x \\ A_y \\ A_z \end{pmatrix}$$

- un vecteur $\vec{H}$ perpendiculaire à $\vec{A}$ et $\vec{g}$ :

$$\vec{H} = \vec{A} \wedge \vec{g} = \begin{pmatrix} A_y g_z - g_y A_z \\ -A_x g_z + g_x A_z \\ A_x g_y - g_x A_y \end{pmatrix} = \begin{pmatrix} H_x \\ H_y \\ H_z \end{pmatrix}$$

$\vec{H}$ est la composante de $\vec{B}$ dans le plan horizontal communément dénommée « Nord magnétique » ;
- la composante de $\vec{g}_P$ dans le plan horizontal ($\vec{A}$, $\vec{H}$) à savoir $\vec{G}$ :

$$\vec{G} = \frac{g_x A_x + g_y A_y}{A_x^2 + A_y^2 + A_z^2} \times \begin{pmatrix} A_x \\ A_y \\ A_z \end{pmatrix} + \frac{g_x H_x + g_y H_y}{H_x^2 + H_y^2 + H_z^2} \times \begin{pmatrix} H_x \\ H_y \\ H_z \end{pmatrix} = \begin{pmatrix} G_x \\ G_y \\ G_z \end{pmatrix}$$

et calculant enfin l'azimut β 2220 entre la direction du nord magnétique $\vec{H}$ et $\vec{G}$ à partir de la formule suivante :

$$\cos(\beta) = \frac{g_x H_x + g_y H_y}{\sqrt{H_x^2 + H_y^2 + H_z^2} \times \sqrt{G_x^2 + G_y^2 + G_z^2}}$$

2300 effectuer la capture optique de la composition de l'environnement tel qu'il est vu du plan P au moyen d'un appareil photo numérique ou d'une caméra équipé d'un objectif dont l'angle du champ de vision est d'au moins 180° de type *"fish-eye"* en réalisant une série d'au moins une, de préférence au moins 4 et, plus préférentiellement encore au moins 6 photos, tout ou partie de ces photos étant de préférence prises avec des temps d'ouverture différents, pour permettre d'obtenir en combinant la ou les photos, l'image la plus détaillée de l'environnement de P,

2400 procéder à l'horodatage de tout ou partie des informations au moyen d'une horloge intégrée sur une carte électronique du boîtier (100).

4. Procédé selon la revendication 3 **caractérisé en ce que** lors de la mesure de l'azimut β 2220, on détermine l'angle de pénétration de $\vec{B}$ dans le plan horizontal à l'aide de la boussole et si cet angle de pénétration présente une dérive de plus de p %, de préférence p = 10 ou mieux encore p = 5, par rapport à la valeur de référence locale de l'angle de pénétration de $\vec{B}$, de préférence, issue d'une base de données telle celle du National Geographical Data Center NGDC, alors la valeur calculée de P est réputée fausse.

5. Procédé selon l'une quelconque des revendications 1 à 4, **caractérisé en ce que** dans l'étape facultative 3000, tout ou partie des données 2100, 2200, 2300, 2400 acquises à l'étape 2000 sont stockées dans au moins une unité de mémoire du boîtier (100) comprenant au moins l'un des éléments suivants : RAM, EEPROMM, Flash, disque dur.

6. Procédé selon l'une quelconque des revendications 1 à 5, **caractérisé en ce que** dans l'étape 4000 tout ou partie des données 2100, 2200, 2300, 2400 acquises à l'étape 2000 sont transmises au serveur 400 de traitement dédié au moyen d'un système de communication destiné à dialoguer avec ledit serveur 400, la communication étant de préférence une liaison filaire et/ou non filaire, de préférence choisie dans le groupe de liaisons comprenant les liaisons filaire série, les liaisons filaire USB, les liaisons non filaire utilisant un standard de communication de type GSM, WiFi, Blue-Tooth ou Wimax; cette transmission s'opérant directement vers le serveur de traitement ou via un PC intermédiaire qui serait relié à un réseau étendu de type haut-débit.

7. Procédé selon l'une quelconque des revendications 1 à 6, **caractérisé en ce que** dans la sous-étape 5100, les données brutes sont traitées par une procédure qui vérifie l'orientation et l'inclinaison du plan P 5110, vérifie ou détermine l'altitude de la localisation de P 5120, combine les photographies "*fish-eye*" pour produire une image précise de l'environnement de P sans zones surexposées ou sous-exposées 5130, aligne au besoin la ou les photographies par rapport au nord 5135, détermine, à partir de l'image issue de 5130, le contour des masques imposés par l'environnement au plan P 5140 puis calcule le facteur 5150 de transmission desdits masques, ainsi que le facteur 5160 de réflexion desdits masques et du sol, le contour des masques de P est utilisé pour déterminer l'influence des masques 5170 sur le rayonnement provenant de la voûte céleste.

8. Procédé selon la revendication 7, **caractérisé en ce que** la sous-étape 5100 comprend au moins l'une des phases suivantes :

• phase 5130 : le serveur 400 combine la série de photographies *"fish-eye"* prises par le boîtier (100) à l'instant t pour construire une image en luminances HDR - High Dynamic Range- de l'environnement de P, cette image étant de préférence obtenue à partir des résultats de l'étalonnage en luminance de l'appareil photo numérique ou de la caméra *"fish-eye"* utilisé, en choisissant avantageusement une relation mathématique de type logarithmique entre la valeur d'un pixel de l'image HDR et la luminance du point de l'environnement de P représenté par ce pixel; l'algorithme du serveur 400 effectuant la combinaison analysant successivement chaque photographie pour ajouter à l'image HDR, la luminance des pixels dont la valeur est préférablement comprise entre 1% et 99%, plus préférablement encore entre 10% et 90% de la valeur maximale possible ;
• phase 5140 : le serveur 400 détermine le contour des masques de P à partir de l'image HDR de l'environnement obtenue en 5130 ;

o en décomposant l'image en deux parties : l'une appartenant au sol et située en dessous de la ligne d'horizon du site comprenant P, l'autre réputée appartenir au ciel et située au dessus de la ligne d'horizon du site comprenant P ;
o en repérant toute variation abrupte de luminance au sein de la zone ciel, le caractère abrupt d'une variation de luminance dans la zone ciel correspondant de préférence à une variation d'au moins 1000% ;
o en vectorisant le contour de chaque masque stocké ensuite dans le tableau de description des masques TDM ;

• phase 5150 : éventuellement le serveur 400 analyse les pixels de l'image HDR appartenant à chacun des masques de P 5140 pour obtenir à partir des écarts de valeur rencontrés, des informations sur le degré d'opacité de chacun des masques, c'est-à-dire son facteur de transmission TRAM, voire sa nature NATM ;
• phase 5160 : le serveur 400 utilise les valeurs des pixels de l'image HDR sont utilisées pour déterminer le facteur de réflexion des masques REFM et du sol REFS donné par le rapport entre la valeur moyenne des luminances appartenant au masque ou au sol et la valeur moyenne des luminances appartenant à la voûte céleste, REFM & REFS étant alors également stockés dans TDM ;
• phase 5170 : les masques ayant une influence sur la transmission et la réflexion du rayonnement solaire diffus provenant de toute la voûte céleste, le serveur 400 calcule l'éclairement énergétique diffus sur le plan P en intégrant l'énergie provenant de différentes zones de la voûte céleste, de préférence au moins une cinquantaine, et, plus préférentiellement encore, au moins une centaine de zones couvrant de préférence la même portion d'espace (le même angle solide), chaque zone

     o étant avantageusement une zone de forme trapézoïdale décrite par ses angles d'azimut et de zénith inférieurs et supérieurs stockés dans un tableau de description des zones du ciel TDZC, et
     o ayant par ailleurs son facteur de transmission TRAZC et son facteur de réflexion REFZC également stockés dans le TDZC,
     TRAZC étant par défaut égal à 1, en l'absence de masque, la zone transmet l'intégralité du rayonnement solaire provenant de cette direction de la voûte céleste,
     REFZC étant par défaut égal à 0, en l'absence de masque, le ciel ne réfléchit pas de rayonnement diffus ;

l'algorithme du serveur 400 pour le calcul de l'éclairement énergétique diffus sur le plan P :

     o détermine, à partir du tableau de description des masques TDM, les zones affectées par chacun des masques et pour chacune d'entre elles le pourcentage de surface de la zone obstruée par le masque,
     o calcule pour chacune des zones affectées par un masque, le facteur de transmission TRAZC par pondération surfacique entre le facteur de transmission du masque TRAM, surface de la zone occupée par le masque et le facteur de transmission de référence égal à 1.0 surface de la zone non occupée par le masque.

**9.** Procédé selon l'une quelconque des revendications 1 à 8, **caractérisé en ce que** dans sous-étape 5200, les informations résultant du traitement 5100 sont ensuite introduites 5210 dans une fiche projet que l'opérateur peut consulter sur le serveur 400 et dans laquelle l'opérateur peut également saisir des informations complémentaires, dont notamment les informations nécessaires au dimensionnement de la chaîne de transformation de l'énergie solaire en énergie électrique, par saisie directe 5220 et/ou par sélection dans un menu 5230.

**10.** Procédé selon l'une quelconque des revendications 1 à 9, **caractérisé en ce que** dans la sous-étape 5300, le serveur 400 extrait des données microclimatiques :

     • choisies dans le groupe comprenant au moins l'une des données suivantes :

     l'éclairement énergétique direct sur un plan perpendiculaire à la direction du soleil ENS, l'éclairement énergétique diffus sur un plan horizontal EHD et la température de l'air extérieur TAE ;

     • et issues d'une base de données :

     o dont la résolution spatiale correspond à une couverture géographique inférieure ou égale à 100 km, de préférence à 10 km, pour prendre en compte les variations microclimatiques ;
     o et dont la résolution temporelle correspond à un pas de temps Pt inférieur ou égal à à l'heure, de préférence à la demi-heure, pour prendre en compte la dynamique des variations du rayonnement solaire, pour chaque jour J, sur une période Pe d'au moins cinq ans, de préférence d'au moins 10 ans.

**11.** Procédé selon l'une quelconque des revendications 1 à 10, **caractérisé en ce que** dans la sous-étape 5400, le serveur 400 :

     • effectue une boucle de calcul sur tous les instants d'un pas de temps Pt', des jours J et d'une période Pe', où Pe' est inférieure ou égale à la période Pe couverte par les données climatiques extraites en 5300, où le pas de temps Pt' est inférieur ou égal à Pt,
     • calcule, dans le cadre de la phase 5410 de calcul de la totalité de l'énergie solaire reçue par P, et pour tous les instants de chaque pas Pt' de la boucle :

o la position du soleil par rapport au plan P 5411,

o de préférence, la contribution énergétique EPS du soleil sur le plan P 5412,

o de préférence, la contribution énergétique EPC de la voûte céleste 5413,

o de préférence, la contribution énergétique EPRM sur le plan P de la réflexion du rayonnement solaire direct sur les masques 5414,

o de préférence, la contribution énergétique EPRS sur le plan P de la réflexion du rayonnement solaire sur le sol 5415,

o et, la contribution énergétique totale ETP sur le plan P = EPS + EPC + EPRM + EPRS,

• calcule, dans le cadre de la phase 5420 et pour tous les instants de chaque pas Pt' de la boucle, l'énergie électrique produite par la chaîne de transformation en multipliant ETP par le rendement de conversion électrique RENP du ou des panneaux solaires photovoltaïques de ladite chaîne, de préférence le rendement nominal RENPNOM à 25°C, de préférence en déduisant les pertes générées par ladite chaîne,

• calcule, dans le cadre de la phase 5421 et pour tous les instants de chaque pas Pt' de la boucle, le RENP, de préférence le RENPNOM à 25°C, en utilisant de préférence un modèle thermique dynamique selon lequel la température TP du ou des panneaux solaires photovoltaïques est déterminée à partir de ETP, la température de l'air TAE au pas Pt' considéré ainsi que la température des panneaux photovoltaïques au pas Pt' précédent de la boucle.

**12.** Procédé selon l'une quelconque des revendications 1 à 11, **caractérisé en ce que** le serveur est susceptible d'être connecté à internet et comprend au moins un ordinateur, de préférence un ordinateur personnel, situé sur un site de l'opérateur et/ou au moins un système informatique délocalisé sur un site internet.

**13.** Dispositif, notamment pour la mise en oeuvre du procédé selon l'une quelconque des revendications 1 à 12, d'évaluation du potentiel de production électrique d'un plan P d'inclinaison et d'orientation quelconques comprenant ou destiné à comprendre au moins un panneau solaire photovoltaïque, ledit panneau étant inclus dans une chaîne de transformation de l'énergie solaire en énergie électrique qui comprend également au moins un onduleur et du câblage, **caractérisé en ce qu'**il comprend

➢ un boîtier (100) intelligent de caractérisation automatique de P et de l'environnement dudit plan P contenant notamment :

■ (110) un système de géo-positionnement satellitaire apte à fournir des données de localisation de P ;

■ (120) au moins deux inclinomètres, avantageusement électronique, de préférence au moins trois accéléromètres formant un trièdre (x, y, z), dont deux des axes (x, y) sont dans le plan de référence P et permettant la mesure des 3 composantes ($g_x$, $g_y$, $g_z$) du vecteur gravitationnel $\vec{g}$, lequel permet d'accéder au vecteur de plus grande pente de P et à la pente $\alpha$ 2210 (inclinaison de P) de son vecteur de plus grande pente, par rapport à l'horizontale ;

■ 130 au moins une boussole, avantageusement électronique de préférence une boussole constituée par un système de mesure du champ magnétique terrestre comprenant au moins trois capteurs magnétiques perpendiculaires entre eux formant un trièdre (x', y', z'), de préférence identique au trièdre (x, y, z) permettant de mesurer les coordonnées ($B_x$, $B_y$, $B_z$) du vecteur du champ magnétique terrestre $\vec{B}$ dans le repère (x, y, z), lesquelles coordonnées permettant d'accéder à l'azimut $\beta$ (orientation de P) du vecteur de plus grande pente de P ;

■ 140 au moins un appareil de photographie ou caméra numérique équipé d'un objectif de type *"fish-eye"* (141) dont l'angle du champ de vision est d'au moins 180°, de préférence au moins un capteur CCD (142), apte à prendre au moins une photographie de l'environnement de P, vu du plan P ;

■ (150) une unité électronique comprenant :

• 151 au moins une mémoire de stockage permettant notamment l'archivage des données acquises à l'étape 2000 ;

• 152 au moins un processeur de calcul et d'exécution d'au moins l'une des étapes 2000, 3000 et 4000, de préférence toutes ;

• 153 au moins un port de connexion et d'identification ;

• (154) éventuellement une horloge temps réel ;

• (155) éventuellement au moins un organe de commande, de préférence au moins un bouton poussoir et/ou au moins une télécommande ;

• (156) une alimentation électrique, de préférence une batterie ;

➢ au moins un serveur 400 dédié auquel ledit boîtier (100) peut être connecté chaque fois qu'il s'agit d'évaluer le potentiel de production électrique d'un plan P, ledit serveur 400 étant de préférence un système informatique délocalisé sur un site internet, lui-même susceptible d'être connecté à internet et notamment à une base de données microclimatiques ;

l'éventuel système informatique délocalisé compris dans le serveur 400 et la base de données microclimatiques étant de préférence accessibles via internet sur un site internet approprié ;

ledit serveur 400 comprenant de préférence des moyens de saisie et de transmission au serveur, d'une part, d'un ou plusieurs paramètres choisis dans le groupe comportant: l'identification de l'opérateur, création de projet, gestion de projets en cours, et, d'autre part, de paramètres nécessaires au calcul et choisis dans le groupe comprenant les caractéristiques des cellules comprises dans le ou les panneaux solaires photovoltaïques et le type de panneau(x) envisagé(s) ;

➢ éventuellement au moins un ordinateur, de préférence un ordinateur personnel, situé sur un site de l'opérateur utile comme intermédiaire dans la connexion au serveur 400 quand celui-ci est un système informatique délocalisé sur un site internet et/ou comme serveur 400.

**14.** Dispositif selon la revendication 13, **caractérisé en ce que** le boîtier (100) contient au moins un module (101) délimité par une coque et comprenant au moins une surface plane (102), cette surface plane (102) étant utile comme référentiel et étant destinée à être disposée dans le plan P ou dans un plan parallèle à P; tout ou partie des moyens (110) à (150) étant en outre disposés dans ce module (101) de préférence parallèlement à cette surface plane (102) ; la face externe (face d'appui) de la semelle (190) du boîtier (100) étant de préférence équipée de moyens antidérapants constitués par un revêtement, par exemple en caoutchouc ou en silicone.

**15.** Dispositif selon la revendication 14, **caractérisé en ce que** le boîtier (100) est conçu pour être déposé sur la surface, e.g. d'un toit, comprenant le plan P et pour s'auto-positionner sur ladite surface de telle sorte que la surface (102) utile comme référentiel soit dans le plan P.

**16.** Dispositif selon la revendication 15, **caractérisé en ce que** la plus petite dimension D du boîtier (100) est suffisamment élevée pour que le boîtier (100), une fois posé sur la surface (e.g. un toit) comprenant le plan P, soit dans un plan contenant les sommets des irrégularités, D étant de préférence supérieure ou égale à la plus petite distance entre deux sommets successifs des irrégularités de la surface, e.g. du toit, et pour permettre à la surface (102) du boîtier (100) de coïncider avec P ou avec un plan parallèle à P.

**17.** Dispositif selon la revendication 15 ou 16, **caractérisé en ce que** le boîtier (100) comporte au moins un moyen de préhension, de préférence au moins une longe (170), localisé sur le côté le plus proche du centre de gravité G du boîtier (100).

**18.** Installation pour l'utilisation du dispositif selon l'une des revendications 13 à 17, dans le cadre de la mise en oeuvre du procédé selon l'une quelconque des revendications 1 à 12, **caractérisée en ce qu'**elle comprend le boîtier (100) et au moins une perche (200), de préférence télescopique, de dépose dudit boîtier (100) sur la surface, e.g. un toit, comprenant le plan P; ledit boîtier (100) étant de préférence celui défini dans la revendication 13 et ladite perche (200) comportant à l'une de ses extrémités, un anneau (230) auquel le boitier (100) peut être suspendu par l'intermédiaire de sa longe (170).

## Claims

**1.** Method for assessing the electric energy potential of a plane P of any inclination and orientation, and comprising or intended to comprise at least one photovoltaic solar panel, said panel being included in a chain for transforming solar energy into electric energy which further comprises at least one inverter and wiring, **characterised in that** it consists substantially:

1000 in implementing at least one intelligent case (100) for automatic characterisation of P and of the environment of said plane P, this case (100) being placed in the plane P;

2000 in launching by means of the case (100) a process for acquiring the following data:

2100 location of P via its latitude and its longitude and, more preferably its altitude;

2200 orientation and inclination of P;

2300 optical capture of the composition of the environment such as it is seen from the plane P more preferably panoramic photographs;
2400 date and time of the acquisition;

3000 possibly in storing all or a portion of the data 2100, 2200, 2300, 2400 acquired in step 2000, for the purposes of a later transfer to a dedicated processing server 400;
4000 in transferring the date 2100, 2200, 2300, 2400 acquired in step 2000 to the dedicated processing server 400;
5000 in processing data, in particular the date 2100, 2200, 2300, 2400 acquired in step 2000, by means of the dedicated processing server 400, in order to calculate the electric energy potential of P, this data processing comprising the following substeps:

5100 processing data 2100, 2200, 2300, 2400 acquired in step 2000 and transmitted in step 4000, in order to locate and determine the influence of the obstacles on the diffuse and direct solar radiations to which may be exposed the plane P, these obstacles located in the environment of P being described by their ability to reflect, transmit or block the diffuse and direct solar radiation;

5200 exchange of information between an operator and the server;
5300 extraction of microclimatic data comprising the direct and diffuse solar energy and possibly the temperature of the air, for the location 2100 of P, and this at a step of time Pt less than or equal to 24 hours, more preferably less than or equal to 1 hour and for a period Pe of at least one full year;
5400 iterative and dynamic calculation of the electric energy potential of P, at a step of time Pt' less than or equal to 24 hours, more preferably less than or equal to 1 hour, and further more preferentially less than or equal to 30 minutes and for a period Pe' of at least one full year, more preferably Pt' & Pe' being respectively and independently equal to Pt & Pe, through the implementation of the following phases:

5410 calculation of the totality of the solar energy received by P by taking into account the influence of the obstacles located in 5100 and of the ground on the diffuse and direct solar radiations;
5420 calculation of the electrical energy produced by the transformation chain, using the solar energy calculated in 5410 by taking into account:

5421 the yield of the panel(s), by possibly integrating into this yield the surface temperature of the panel(s) obtained using the temperature possible extracted in 5300; 5422 and possibly additional losses due to the inverter(s) and to the wiring;

6000 in printing the results of the calculations in the form of report(s), more preferably transmitted in the case (100), and/or presented on the screen of the server and/or printed.

2. Method according to claim 1, **characterised in that** the step 1000 consists in placing the case (100) on the plane P, by means of at least one tool, more preferably a staff, for placing the case 100 on the plane P.

3. Method according to claim 1 or 2, **characterised in that** the step 2000 of acquiring data consists substantially in:

2100 determining the longitude, the latitude and possibly the altitude of P by means of a satellite global positioning system GPS.
2200 determining:

■ 2210: on the one hand, the inclination of P in relation to the vertical of the location through the angle in relation to the horizontal [slope a 2210] of its vector with the greatest slope, more preferably by means of at least two electronic inclinometers, and, further more preferentially by means of at least three accelerometers perpendicular to one another, forming a trihedron (x, y, z), of which two of the axes (x, y) are in the reference plane P and making possible the measurement of the 3 components ($g_x$, $g_y$, $g_z$) of the gravitational vector $\vec{g}$, which defines the vertical of the location and of which the projection $\vec{g}_P = (g_x, g_y, 0)$ in the plane P, gives the vector with the greatest slope, the slope a between $\vec{g}$ and $\vec{g}_P$ being given by

$$\cos(\alpha) = \frac{\sqrt{g_x^2 + g_y^2}}{\sqrt{g_x^2 + g_y^2 + g_z^2}}$$

■ 2220: and, on the other hand, the orientation of P through its azimuth β 2220 more preferably the azimuth β of its vector with the greatest slope in relation to the north (advantageously the magnetic north), by means of a compass, more preferably a compass constituted of a system for measuring the terrestrial magnetic field comprising at least three magnetic sensors perpendicular to one other forming a trihedron (x', y', z'), more preferably identical to the trihedron (x, y, z), of which two axes (x, y) are in the reference plane P and making it possible to measure the coordinates $(B_x, B_y, B_z)$ of the vector of the terrestrial magnetic field $\vec{B}$ in the index (x, y, z);

the intelligent case (100) then defining:

- a vector $\vec{A}$ perpendicular to $\vec{B}$ and $\vec{g}$:

$$\vec{A} = \vec{B} \wedge \vec{g} = \begin{pmatrix} B_y g_z - g_y B_z \\ -B_x g_z + g_x B_z \\ B_x g_y - g_x B_y \end{pmatrix} = \begin{pmatrix} A_x \\ A_y \\ A_z \end{pmatrix}$$

- a vector $\vec{H}$ perpendicular to $\vec{A}$ and $\vec{g}$:

$$\vec{H} = \vec{A} \wedge \vec{g} = \begin{pmatrix} A_y g_z - g_y A_z \\ -A_x g_z + g_x A_z \\ A_x g_y - g_x A_y \end{pmatrix} = \begin{pmatrix} H_x \\ H_y \\ H_z \end{pmatrix}$$

$\vec{H}$ is the component of $\vec{B}$ in the horizontal plane commonly denominated as «Magnetic north»;
- the component of $\vec{g}_P$ in the horizontal plane $(\vec{A}, \vec{H})$ i.e. $\vec{G}$:

$$\vec{G} = \frac{g_x A_x + g_y A_y}{A_x^2 + A_y^2 + A_z^2} \times \begin{pmatrix} A_x \\ A_y \\ A_z \end{pmatrix} + \frac{g_x H_x + g_y H_y}{H_x^2 + H_y^2 + H_z^2} \times \begin{pmatrix} H_x \\ H_y \\ H_z \end{pmatrix} = \begin{pmatrix} G_x \\ G_y \\ G_z \end{pmatrix}$$

and calculating finally the azimuth β 2220 between the direction of magnetic north $\vec{H}$ and $\vec{G}$ using the following formula:

$$\cos(\beta) = \frac{g_x H_x + g_y H_y}{\sqrt{H_x^2 + H_y^2 + H_z^2} \times \sqrt{G_x^2 + G_y^2 + G_z^2}}$$

2300 carrying out the optical capture of the composition of the environment such as it is seen from the plane P by means of a digital photo camera or of a camera provided with a lens of which the angle of the field of vision is of at least 180° of the "fish-eye" type by taking a series of at least one, more preferably at least 4 and, further more preferably at least 6 photos, all or a portion of these photos being more preferably taken with different opening times, in order to make it possible to obtain by combining the photo(s), the most detailed image of the environment of P,

2400 proceeding with the time/date stamping of all or a portion of the information by means of a clock incorporated on an electronic board of the case (100).

4. Method according to claim 3 **characterised in that** during the measurement of the azimuth β 2220, the angle of penetration of $\vec{B}$ in determined in the horizontal plane using the compass and if this angle of penetration has a deviation of more than p%, more preferably p = 10 or even better p = 5, in relation to the local reference value of the angle of penetration of $\vec{B}$, more preferably, coming from a database such as that of the National Geographical Data Center NGDC, then the calculated value of β is considered incorrect.

5. Method according to any of claims 1 to 4, **characterised in that** in the optional step 3000, all or a portion of the data 2100, 2200, 2300, 2400 acquired in step 2000 is stored in at least one memory unit of the case (100) comprising at least one of the following elements: RAM, EEPROMM, Flash, hard drive.

6. Method according to any of claims 1 to 5, **characterised in that** in the step 4000 all or a portion of the data 2100, 2200, 2300, 2400 acquired in step 2000 is transmitted to the dedicated processing server 400 by means of a communication system intended to dialogue with said server 400, the communication being more preferably a wired and/or wireless connection, more preferably selected from the group of connections comprising serial wired connections, USB wired connection, the wireless connections using a communication standard of the GSM, WiFi, Blue-Tooth or Wimax type; this transmission operating directly towards the processing server or via an intermediate PC that would be connected to an extended network of the high-speed type.

7. Method according to any of claims 1 to 6, **characterised in that** in the substep 5100, the raw data is processed by a procedure that checks the orientation and the inclination of the plane P 5110, checks or determines the altitude of the location of P 5120, combines the "fish-eye" photographs in order to produce a precise image of the environment of P without underexposed or overexposed zones 5130, aligns as needed the photograph(s) in relation to the north 5135, determines, using the image coming from 5130, the outline of the masks imposed by the environment to the plane P 5140 then calculates the transmission factor 5150 of said masks, as well as the reflection factor 5160 of said masks and of the ground, the outline of the masks of P is used in order to determine the influence of the masks 5170 on the radiation coming from the vault of heaven.

8. Method according to claim 7, **characterised in that** the substep 5100 comprises at least one of the following phases:

   • phase 5130: the server 400 combines the series of "fish-eye" photographs taken by the case (100) at instant t in order to compile an image in HDR -High Dynamic Range- luminances of the environment of P, this image being more preferably obtained using the results of the calibration in luminance of the digital photo camera or of the "fish-eye" camera used, by advantageously choosing a mathematical relation of the logarithmic type between the value of a pixel of the HDR image and the luminance of the point of the environment of P represented by this pixel; the algorithm of the server 400 carrying out the combination successively analysing each photograph in order to add to the HDR image, the luminance of the pixels of which the value is preferably between 1% and 99%, further more preferably between 10% and 90% of the maximum value possible;

   • phase 5140: the server 400 determines the outline of the masks of P using the HDR image of the environment obtained in 5130;

      o by decomposing the image into two portions: one belonging to the ground and located below the line of the horizon of the site comprising P, the other considered to belong to the sky and located above the line of the horizon of the site comprising P;

      o by locating any abrupt value of luminance within the sky zone, the abrupt nature of a variation of luminance in the sky zone corresponding more preferably to a variation of at least 1000%;

      o by vectorising the outline of each masque stored then in the mask description table TDM;

   • phase 5150: possibly the server 400 analyses the pixels of the HDR image belonging to each of the masks of P 5140 in order to obtain using the differences encountered, information on the degree of opacity of each of the masks, i.e. its transmission factor TRAM, and even its nature NATM;

• phase 5160: the server 400 uses the values of the pixels of the HDR image in order to determine the reflection factor of the masks REFM and of the ground REFS given by the ratio between the average value of the luminances belonging to the mask or to the ground and the average value of the luminances belonging to the vault of heaven, REFM & REFS then also being stored in TDM;

• phase 5170: the masks having an influence on the transmission and the reflection of the diffuse solar radiation coming from all of the vault of heaven, the server 400 calculates the diffuse irradiance on the plane P by integrating the energy coming from different zones of the vault of heaven, more preferably at least about fifty, and, further more preferentially, at least about a hundred zones covering more preferably the same portion of space (the same solid angle), each zone

   o being advantageously a zone of trapezoidal shape described by its lower and upper azimuth and zenith angles stored in a sky zone description table TDZC, and
   o having moreover its transmission factor TRAZC and its reflection factor REFZC also stored in the TDZC, TRAZC being by default equal to 1, in the absence of a mask, the zone transmits all of the solar radiation coming from this direction of the vault of heaven,
   REFZC being by default equal to 0, in the absence of a mask, the sky does not reflect diffuse radiation;

the algorithm of the server 400 for the calculation of the diffuse irradiance on the plane P:

   o determines, using the mask description table TDM, the zones affected by each of the masks and for each of them the percentage of the zone obstructed by the mask,
   o calculates for each of the zones affected by a mask, the transmission factor TRAZC via surface weighting between the transmission factor of the mask TRAM, surface of the zone occupied by the mask and the reference transmission factor equal to 1.0 surface of the zone not occupied by the mask.

9. Method according to any of claims 1 to 8, **characterised in that** in substep 5200, the information resulting from the processing 5100 is then introduced 5210 into a project sheet which can be consulted by the operator on the server 400 and wherein the operator can also enter additional information, of which in particular the information required to dimension the chain for transforming solar energy into electric energy, by direct key entry 5220 and/or by selection in a menu 5230.

10. Method according to any of claims 1 to 9, **characterised in that** in the substep 5300, the server 400 extracts microclimatic data:

   • selected from the group comprising at least one of the following pieces of data: the direct irradiance on a plane perpendicular to the direction of the sun ENS, the diffuse irradiance on a horizontal plane EHD and the temperature of the outside air TAE;
   • and coming from a database:

      o of which the spatial resolution corresponds to a geographical coverage less than or equal to 100 km, more preferably to 10 km, in order to take into account the microclimatic variations;
      o and of which the temporal resolution corresponds to a step of time Pt less than or equal to the time, more preferably to the half-hour, in order to take into account the dynamics of the variations of the solar radiation, for each day D, over a period Pe of at least five years, more preferably of at least 10 years.

11. Method according to any of claims 1 to 10, **characterised in that** in the substep 5400, the server 400:

   • carries out a calculation loop over all of the instants of a step of time Pt', of the days D and of a period Pe', where Pe' is less than or equal to the period Pe covered by the climatic data extracted in 5300, where the step of time Pt' is less than or equal to Pt,
   • calculates, within the framework of the calculation phase 5410 the totality of the solar energy received by P, and for all of the instants of each step Pt' of the loop:

      o the position of the sun in relation to plane P 5411,
      o more preferably, the energy contribution EPS of the sun on the plane P 5412,
      o more preferably, the energy contribution EPC of the vault of heaven 5413,
      o more preferably, the energy contribution EPRM on the plane P of the reflection of the direct solar radiation on the masks 5414,

o more preferably, the energy contribution EPRS on the plane P of the reflection of the solar radiation on the ground 5415,

o and, the total energy contribution ETP on the plane P = EPS + EPC + EPRM + EPRS,

- calculates, within the framework of the phase 5420 and for all of the instants of each step Pt' of the loop, the electrical energy produced by the transformation chain by multiplying ETP by the electrical conversion yield RENP of the photovoltaic solar panel(s) of said chain, more preferably the nominal yield RENPNOM at 25˚C, more preferably by deducting the losses generated by said chain,

- calculates, within the framework of the phase 5421 and for all of the instants of each step Pt' of the loop, the RENP, more preferably the RENPNOM at 25˚C, by using more preferably a dynamic thermal model according to which the temperature TP of the photovoltaic solar panel(s) is determined using ETP, the temperature of the air TAE at step Pt' considered as well as the temperature of the photovoltaic panels at the previous step Pt' of the loop.

12. Method according to any of claims 1 to 11, **characterised in that** the server is able to be connected to internet and comprises at least one computer, more preferably a personal computer, located on a site of the operator and/or at least one off-site computer system on an internet site.

13. Device, in particular for implementing the method according to any of claims 1 to 12, for assessing the electric energy potential of a plane P of any inclination and orientation, and compressing or intended to comprise at least one photovoltaic solar panel, said panel being included in a chain for transforming solar energy into electric energy which further comprises at least one inverter and wiring, **characterised in that** it comprises

➤ an intelligent case (100) for the automatic characterisation of P and of the environment of said plane P containing in particular:

■ (110) a satellite global positioning system able to provide data for locating P;

■ (120) at least two inclinometers advantageously electronic, more preferably at least three accelerometers forming a trihedron (x, y, z), of which two of the axes (x, y) are in the reference plane P and which make it possible to measure the 3 components ($g_x$, $g_y$, $g_z$) of the gravitational vector $\vec{g}$, which makes it possible to access the vector with the greatest slope of P and the slope a 2210 (inclination of P) of its vector with the greatest slope, in relation to the horizontal;

■ 130 at least one compass, advantageously electronic, more preferably a compass constituted by a system for measuring the terrestrial magnetic field comprising at least three magnetic sensors perpendicular to one other forming a trihedron (x', y', z'), more preferably identical to the trihedron (x, y, z) making it possible to measure the coordinates ($B_x$, $B_y$, $B_z$) of the vector of the terrestrial magnetic field $\vec{B}$ in the index (x, y, z), coordinates that make it possible to access the azimuth β (orientation of P) of the vector with the greatest slope of P;

■ 140 at least one photograph device or digital camera provided with a lens of the "fish-eye" type (141) of which the angle of the field of vision is at least 180˚, more preferably at least one CCD sensor (142), able to take at least one photograph of the environment of P, seen from plane P;

■ (150) an electronic unit comprising:

- 151 at least one specification for storage making possible in particular the archiving of the data acquired in step 2000;
- 152 at least one processor for calculating and for executing at least one of the steps 2000, 3000 and 4000, more preferably all of them;
- 153 at least one port for connection and for identification;
- (154) possibly a real time clock;
- (155) possibly at least one member for controlling, more preferably at least one push-button and/or at least one remote control;
- (156) an electrical power supply, more preferably a battery;

➤ at least one dedicated server 400 to which said case (100) can be connected each time that it entails assessing the electric energy potential of a plane P, said server 400 being more preferably an off-site computer system on an internet site, itself able to be connected to internet and in particular to a database of microclimatic data; the possible off-site computer system included in the server 400 and the database of microclimatic data being more preferably accessible via internet on an appropriate internet site;

said server 400 comprising more preferably means for key entry and for transmitting to the server, on the one hand, one or several parameters selected from the group comprising: the identification of the operator, project creation, management of current projects, and, on the other hand, parameters required for the calculation and selected from the group comprising the characteristics of the cells included in the photovoltaic solar panel(s) and the type of panel(s) considered;

➣ possibly at least one computer, more preferably a personal computer, located on a site of the operator useful as an intermediary in the connection to the server 400 when the latter is an off-site computer system on an internet site and/or as server 400.

**14.** Device according to claim 13, **characterised in that** the case (100) contains at least one module (101) delimited by a shell and comprising at least one planar surface (102), this planar surface (102) being useful as a referential and being intended to be arranged in the plane P or in a plane parallel to P; all or a portion of the means (110) to (150) being furthermore arranged in this module (101) more preferably in parallel to this planar surface (102); the external face (bearing face) of the soleplate (190) of the case (100) being more preferably provided with anti-skid means constituted of a covering, for example made of rubber or of silicone.

**15.** Device according to claim 14, **characterised in that** the case (100) is designed to be placed on the surface, e.g. of a roof, comprising the plane P and to position itself on said surface in such a way that the surface (102) useful as a referential is in the plane P.

**16.** Device according to claim 15, **characterised in that** the smallest dimension D of the case (100) is high enough so that the case (100), once placed on the surface (e.g. a roof) comprising the plane P, is in a plane containing the peaks of the irregularities, D being more preferably greater than or equal to the smallest distance between two successive peaks of the irregularities of the surface, e.g. of the roof, and in order to allow the surface (102) of the case (100) to coincide with P or with a plane parallel to P.

**17.** Device according to claim 15 or 16, **characterised in that** the case (100) comprises at least one means for grasping, more preferably at least one tether (170), located on the side nearest the centre of gravity G of the case (100).

**18.** Installation for the use of the device according to one of claims 13 to 17, within the framework of the implementation of the method according to any of claims 1 to 12, **characterised in that** it comprises the case (100) and at least one staff (200), more preferably telescopic, for placing said case (100) on the surface, e.g. a roof, comprising the plane P; said case (100) being more preferably that defined in claim 13 and said staff (200) comprising at one of its ends, a ring (230) to which the case (100) can be suspended by the intermediary of its tether (170).

**Patentansprüche**

**1.** Verfahren zur Auswertung des Stromerzeugungspotentials einer Ebene P mit beliebiger Neigung und Orientierung, die mindestens ein Photovoltaik-Solarzellenpanel aufweist oder aufweisen soll, wobei das Panel in einem Kanal zur Umwandlung von Sonnenenergie in elektrische Energie enthalten ist, der auch mindestens einen Wechselrichter und eine Verkabelung aufweist, **dadurch gekennzeichnet, dass** es im Wesentlichen aus Folgendem besteht:

1000 Einsetzen mindestens eines intelligenten Gehäuses (100) zur automatischen Charakterisierung von P und der Umgebung der Ebene P, wobei dieses Gehäuse (100) in die Ebene P gelegt ist;
2000 Starten eines Prozesses zur Erfassung der folgenden Daten mittels des Gehäuses (100):

2100 Lokalisierung von P durch ihren Breitengrad und ihren Längengrad und vorzugsweise ihre Höhenlage;
2200 Orientierung und Neigung von P;
2300 Optische Aufnahme der Zusammensetzung der Umgebung, wie sie aus der Ebene P gesehen wird, vorzugsweise Panoramaphotographien;
2400 Datum und Uhrzeit der Erfassung;

3000 möglicherweise Speichern von allem oder einem Teil der in Schritt 2000 erfassten Daten 2100, 2200, 2300, 2400 im Hinblick auf eine spätere Übertragung zu einem dedizierten Verarbeitungsserver 400;
4000 Übertragen der in Schritt 2000 erfassten Daten 2100, 2200, 2300, 2400 zu dem dedizierten Verarbeitungsserver 400;

5000 Verarbeiten der Daten, insbesondere der in Schritt 2000 erfassten Daten 2100, 2200, 2300, 2400, mittels des dedizierten Verarbeitungsservers 400, um das Stromerzeugungspotential von P zu berechnen, wobei diese Datenverarbeitung die folgenden Unterschritte aufweist:

5100 Verarbeitung der in Schritt 2000 erfassten und in Schritt 4000 übertragenen Daten 2100, 2200, 2300, 2400, um Hindernisse zu lokalisieren und deren Einfluss auf die direkten und gestreuten Sonnenstrahlen zu bestimmen, denen die Ebene P möglicherweise ausgesetzt ist, wobei diese Hindernisse, die in der Umgebung von P liegen, durch ihre Fähigkeit, die direkte oder gestreute Sonnenstrahlung zu reflektieren, durchzulassen oder zu blockieren, beschrieben werden;

5200 Austausch von Informationen zwischen einem Operator und dem Server;

5300 Gewinnung von mikroklimatischen Daten mit der direkten und gestreuten Sonnenenergie und möglicherweise der Temperatur der Luft für die Lokalisierung 2100 von P, und zwar in einem Zeitschritt Pt, der kleiner als oder gleich 24 Stunden, vorzugsweise kleiner als oder gleich 1 Stunde ist, und für eine Periode Pe von mindestens einem ganzen Jahr;

5400 iterative und dynamische Berechnung des Stromerzeugungspotentials von P in einem Zeitschritt Pt', der kleiner als oder gleich 24 Stunden, vorzugsweise kleiner als oder gleich 1 Stunde und noch bevorzugter kleiner als oder gleich 30 Minuten ist, und für eine Periode Pe' von mindestens einem ganzen Jahr, wobei vorzugsweise Pt' & Pe' jeweils und unabhängig gleich Pt & Pe sind, durch Ausführung der folgenden Phasen:

5410 Berechnung der Gesamtheit der von P empfangenen Sonnenenergie unter Berücksichtigung des Einflusses der in 5100 lokalisierten Hindernisse und des Bodens auf die direkten und gestreuten Sonnenstrahlen;

5420 Berechnung der durch den Umwandlungskanal erzeugten elektrischen Energie anhand der in 5410 berechneten Sonnenenergie unter Berücksichtigung von Folgendem:

5421 des Wirkungsgrades des Panels oder der Panele durch eventuelles Integrieren der Oberflächentemperatur des Panels oder der Panele in diesen Wirkungsgrad, die anhand der eventuell in 5300 gewonnenen Temperatur erhalten wird;

5422 und möglicherweise der zusätzlichen Verluste aufgrund des (der) Wechselrichter(s) und der Verkabelung;

6000 Aufbereiten der Ergebnisse der Berechnungen in Form eines Verhältnisses (von Verhältnissen), die vorzugsweise zum Gehäuse (100) übertragen werden und/oder auf dem Bildschirm des Servers dargestellt werden und/oder ausgedruckt werden.

2. Verfahren nach Anspruch 1, **dadurch gekennzeichnet, dass** der Schritt 1000 darin besteht, das Gehäuse (100) auf die Ebene P mittels mindestens eines Werkzeugs, vorzugsweise einer Stange, zur Ablage des Gehäuses 100 auf der Ebene P zu legen.

3. Verfahren nach Anspruch 1 oder 2, **dadurch gekennzeichnet, dass** der Schritt 2000 zur Erfassung der Daten im Wesentlichen aus Folgendem besteht:

2100 Bestimmen des Längengrads, des Breitengrads und eventuell der Höhenlage von P mittels eines globalen Satelliten- Positionsbestimmungssystems GPS.

2200 Bestimmen von Folgendem:

→ 2210: einerseits der Neigung von P in Bezug auf die Vertikale des Orts mittels des Winkels in Bezug auf die Horizontale [Neigung $\alpha$ 2210] ihres Vektors mit größter Neigung, vorzugsweise mittels mindestens zwei elektronischer Neigungsmesser und noch bevorzugter mittels mindestens drei zueinander senkrechter Beschleunigungsmesser, die einen Trieder (x, y, z) bilden, von dem zwei Achsen (x, y) in der Referenzebene P liegen und die Messung der 3 Komponenten ($g_x$, $g_y$, $g_z$) des Gravitationsvektors $\vec{g}$ ermöglichen, der die Vertikale des Orts definiert und dessen Projektion $\vec{g_p}$ = ($g_x$, $g_y$, 0) in der Ebene P den Vektor mit größter Neigung gibt, wobei die Neigung $\alpha$ zwischen $\vec{g}$ und $\vec{g_p}$, durch

$$\cos(\alpha) = \frac{\sqrt{g_x^2 + g_y^2}}{\sqrt{g_x^2 + g_y^2 + g_z^2}}$$

gegeben ist,

→ 2220: und andererseits der Orientierung von P mittels ihres Azimuts β 2220, vorzugsweise des Azimuts β ihres Vektors mit größter Neigung in Bezug auf den Norden (vorteilhafterweise den magnetischen Norden), mittels eines Kompasses, vorzugsweise eines Kompasses, der aus einem System zur Messung des Erdmagnetfeldes mit mindestens drei zueinander senkrechten magnetischen Sensoren besteht, die einen Trieder (x', y', z') bilden, der vorzugsweise zum Trieder (x, y, z) identisch ist, von dem zwei Achsen (x, y) in der Referenzebene P liegen und es ermöglichen, die Koordinaten $(B_x, B_y, B_z)$ des Vektors des Erdmagnetfeldes $\overline{B}$ im Koordinatensystem (x, y, z) zu messen; wobei das intelligente Gehäuse (100) anschließend Folgendes definiert:

- einen Vektor $\vec{A}$, der zu $\vec{B}$ und $\overleftrightarrow{g}$ senkrecht ist:

$$\vec{A} = \vec{B} \wedge \vec{g} = \begin{pmatrix} B_y g_z - g_y B_z \\ -B_x g_z + g_x B_z \\ B_x g_y - g_x B_y \end{pmatrix} = \begin{pmatrix} A_x \\ A_y \\ A_z \end{pmatrix}$$

- einen Vektor $\vec{H}$, der zu $\vec{A}$ und $\vec{g}$ senkrecht ist:

$$\vec{H} = \vec{A} \wedge \vec{g} = \begin{pmatrix} A_y g_z - g_y A_z \\ -A_x g_z + g_x A_z \\ A_x g_y - g_x A_y \end{pmatrix} = \begin{pmatrix} H_x \\ H_y \\ H_z \end{pmatrix}$$

$\vec{H}$ ist die Komponente von $\vec{B}$ in der horizontalen Ebene, die gemeinhin "magnetischer Norden" genannt wird;
- die Komponente von $\vec{g}_p$ in der horizontalen Ebene $(\vec{A}, \vec{H})$, nämlich $\vec{G}$:

$$\vec{G} = \frac{g_x A_x + g_y A_y}{A_x^2 + A_y^2 + A_z^2} \times \begin{pmatrix} A_x \\ A_y \\ A_z \end{pmatrix} + \frac{g_x H_x + g_y H_y}{H_x^2 + H_y^2 + H_z^2} \times \begin{pmatrix} H_x \\ H_y \\ H_z \end{pmatrix} = \begin{pmatrix} G_x \\ G_y \\ G_z \end{pmatrix}$$

und schließlich den Azimut β 2220 zwischen der Richtung des magnetischen Nordens $\vec{H}$ und $\vec{G}$ anhand der folgenden Formel berechnet:

$$\cos(\beta) = \frac{g_x H_x + g_y H_y}{\sqrt{H_x^2 + H_y^2 + H_z^2} \times \sqrt{G_x^2 + G_y^2 + G_z^2}}$$

2300 Durchführen der optischen Aufnahme der Zusammensetzung der Umgebung, wie sie aus der Ebene P gesehen wird, mittels eines digitalen Photoapparats oder einer Kamera, der/die mit einem Objektiv, dessen Sehfeldwinkel mindestens 180° ist, des Typs "Fischauge" ausgestattet ist, durch Erzielen einer Reihe von mindestens einem, vorzugsweise mindestens 4 und noch bevorzugter mindestens 6 Photos, wobei alles oder ein Teil dieser Photos vorzugsweise mit verschiedenen Öffnungszeiten aufgenommen wird, um es zu ermöglichen, durch Kombinieren des oder der Photos das detaillierteste Bild der Umgebung von P zu erhalten,

2400 Durchführen der Zeitstempelung von allem oder einem Teil der Informationen mittels eines in einer elektronischen Karte des Gehäuses (100) integrierten Taktgebers.

4. Verfahren nach Anspruch 3, **dadurch gekennzeichnet, dass** bei der Messung des Azimuts β 2220 der Eindring-

winkel von $\vec{B}$ in der horizontalen Ebene mit Hilfe des Kompasses bestimmt wird, und wenn dieser Eindringwinkel eine Abweichung von mehr als p %, vorzugsweise p = 10 oder noch besser p = 5, in Bezug auf den lokalen Referenzwert des Eindringwinkels von $\vec{B}$ aufweist, der vorzugsweise von einer Datenbank wie jener des National Geographical Data Center NGDC stammt, dann der berechnete Wert von β für falsch gehalten wird.

5. Verfahren nach einem der Ansprüche 1 bis 4, **dadurch gekennzeichnet, dass** im wahlfreien Schritt 3000 alles oder ein Teil der in Schritt 2000 erfassten Daten 2100, 2200, 2300, 2400 in mindestens einer Speichereinheit des Gehäuses (100) mit mindestens einem der folgenden Elemente: RAM, EEPROMM, Flash, Festplatte, gespeichert wird.

6. Verfahren nach einem der Ansprüche 1 bis 5, **dadurch gekennzeichnet, dass** im Schritt 4000 alles oder ein Teil der in Schritt 2000 erfassten Daten 2100, 2200, 2300, 2400 zum dedizierten Verarbeitungsserver 400 mittels eines Kommunikationssystems übertragen wird, das mit dem Server 400 in Dialogverkehr stehen soll, wobei die Kommunikation vorzugsweise eine Draht- und/oder drahtlose Verbindung ist, die vorzugsweise aus der Gruppe von Verbindungen ausgewählt ist, die die Seriendrahtverbindungen, die USB-Drahtverbindungen, die drahtlosen Verbindungen unter Verwendung eines Kommunikationsstandards des Typs GSM, WiFi, Blue-Tooth oder Wimax aufweist; wobei diese Übertragung direkt zum Verarbeitungsserver oder über einen Zwischen-PC erfolgt, der mit einem weitläufigen Netz des Breitbandtyps verbunden wäre.

7. Verfahren nach einem der Ansprüche 1 bis 6, **dadurch gekennzeichnet, dass** im Unterschritt 5100 die Rohdaten durch eine Prozedur verarbeitet werden, die die Orientierung und die Neigung der Ebene P überprüft 5110, die Höhenlage der Lokalisierung von P überprüft oder bestimmt 5120, die "Fischauge"-Photographien kombiniert, um ein genaues Bild der Umgebung von P ohne überbelichtete oder unterbelichtete Zonen zu erzeugen 5130, bei Bedarf die Photographie(n) in Bezug auf den Norden ausrichtet 5135, anhand des von 5130 stammenden Bildes die Kontur der Masken, die durch die Umgebung der Ebene P auferlegt werden, bestimmt 5140, dann den Durchlassgrad 5150 der Masken sowie den Reflexionsgrad 5160 der Masken und des Bodens berechnet, die Kontur der Masken von P wird verwendet, um den Einfluss der Masken 5170 auf die vom Himmelsgewölbe stammende Strahlung zu bestimmen.

8. Verfahren nach Anspruch 7, **dadurch gekennzeichnet, dass** der Unterschritt 5100 mindestens eine der folgenden Phasen aufweist:

• Phase 5130: der Server 400 kombiniert die Reihe von "Fischauge"-Photographien, die vom Gehäuse (100) im Zeitpunkt t aufgenommen wurden, um ein Bild aus Leuchtdichten HDR - High Dynamic Range - der Umgebung von P zu konstruieren, wobei dieses Bild vorzugsweise anhand der Ergebnisse der Leuchtdichtekalibrierung des verwendeten digitalen Photoapparats oder der verwendeten "Fischauge"-Kamera erhalten wird, indem vorteilhafterweise eine mathematische Beziehung des logarithmischen Typs zwischen dem Wert eines Pixels des HDR-Bildes und der Leuchtdichte des Punkts der Umgebung von P, der durch dieses Pixel dargestellt wird, gewählt wird; wobei der Algorithmus des Servers 400 die Kombination durchführt, die nacheinander jede Photographie analysiert, um zum HDR-Bild die Leuchtdichte der Pixel hinzuzufügen, deren Wert vorzugsweise zwischen 1 % und 99 %, noch bevorzugter zwischen 10 % und 90 % des maximalen möglichen Werts liegt;
• Phase 5140: der Server 400 bestimmt die Kontur der Masken von P anhand des in 5130 erhaltenen HDR-Bildes der Umgebung;

o durch Zerlegen des Bildes in zwei Teile: wobei einer zum Boden gehört und unter der Horizontlinie des Orts, der P enthält, liegt, der andere zum Himmel gehören soll und über der Horizontlinie des Orts, der P enthält, liegt;
o durch Auffinden jeglicher abrupten Veränderung der Leuchtdichte im Inneren der Himmelszone, wobei der abrupte Charakter einer Veränderung der Leuchtdichte in der Himmelszone vorzugsweise einer Veränderung von mindestens 1000 % entspricht;
o durch Vektorisieren der Kontur jeder Maske, die anschließend in der Tabelle zur Beschreibung der Masken TDM gespeichert wird;

• Phase 5150: möglicherweise analysiert der Server 400 die Pixel des HDR-Bildes, die zu jeder der Masken von P gehören 5140, um anhand der angetroffenen Wertabweichungen Informationen über den Grad der Lichtundurchlässigkeit von jeder der Masken, das heißt ihren Durchlassgrad TRAM, nämlich ihre Art NATM, zu erhalten;
• Phase 5160: der Server 400 verwendet die Werte der Pixel des HDR-Bildes, die verwendet werden, um den Reflexionsgrad der Masken REFM und des Bodens REFS zu bestimmen, der durch das Verhältnis zwischen dem Mittelwert der Leuchtdichten, die zur Maske oder zum Boden gehören, und dem Mittelwert der Leuchtdichten, die zum Himmelsgewölbe gehören, gegeben wird, wobei REFM & REFS folglich ebenfalls in der TDM gespeichert werden;

• Phase 5170: da die Masken einen Einfluss auf den Durchlass und die Reflexion der gestreuten Sonnenstrahlung, die vom ganzen Himmelsgewölbe stammt, haben, berechnet der Server 400 die gestreute Bestrahlungsstärke auf der Ebene P durch Integrieren der Energie, die von verschiedenen Zonen des Himmelsgewölbes stammt, vorzugsweise mindestens etwa fünfzig und noch bevorzugter mindestens etwa hundert Zonen, die vorzugsweise denselben Abschnitt des Raums (denselben Raumwinkel) abdecken, wobei jede Zone

  o vorteilhafterweise eine Zone mit Trapezform ist, die durch ihre unteren und oberen Azimut- und Zenitwinkel beschrieben wird, die in einer Tabelle zur Beschreibung der Zonen des Himmels TDZC gespeichert werden, und
  o außerdem ihr Durchlassgrad TRAZC und ihr Reflexionsgrad REFZC auch in der TDZC gespeichert werden,
  wobei TRAZC standardmäßig gleich 1 ist, bei Abwesenheit einer Maske lässt die Zone die Gesamtheit der Sonnenstrahlung, die aus dieser Richtung des Himmelsgewölbes stammt, durch,
  wobei REFZC standardmäßig gleich 0 ist, bei Abwesenheit einer Maske reflektiert der Himmel keine gestreute Strahlung;

der Algorithmus des Servers 400 für die Berechnung der gestreuten Bestrahlungsstärke auf der Ebene P:

  o bestimmt anhand der Tabelle zur Beschreibung der Masken TDM die von jeder der Masken betroffenen Zonen und für jede von ihnen den Prozentsatz der Oberfläche der Zone, die durch die Maske versperrt ist,
  o berechnet für jede der von einer Maske betroffenen Zonen den Durchlassgrad TRAZC durch Oberflächengewichtung zwischen dem Durchlassgrad der Maske TRAM, der Oberfläche der Zone, die von der Maske belegt ist, und dem Referenzdurchlassgrad gleich 1,0 Oberfläche der Zone, die nicht von der Maske belegt ist.

**9.** Verfahren nach einem der Ansprüche 1 bis 8, **dadurch gekennzeichnet, dass** im Unterschritt 5200 die Informationen, die sich aus der Verarbeitung 5100 ergeben, anschließend in ein Projektblatt eingetragen werden 5210, das der Operator auf dem Server 400 nachsehen kann und in dem der Operator auch ergänzende Informationen, darunter insbesondere die Informationen, die für die Dimensionierung des Kanals zur Umwandlung der Sonnenenergie in elektrische Energie erforderlich sind, durch direkte Erfassung 5220 und/oder durch Auswahl in einem Menü 5230 erfassen kann.

**10.** Verfahren nach einem der Ansprüche 1 bis 9, **dadurch gekennzeichnet, dass** im Unterschritt 5300 der Server 400 mikroklimatische Daten gewinnt:

  • die aus der Gruppe ausgewählt sind, die mindestens eine der folgenden Daten aufweist: direkte Bestrahlungsstärke auf einer zur Richtung der Sonne senkrechten Ebene ENS, gestreute Bestrahlungsstärke auf einer horizontalen Ebene EHD und die Temperatur der Außenluft TAE;
  • und von einer Datenbank stammen:

  o deren räumliche Auflösung einer geographischen Abdeckung entspricht, die kleiner als oder gleich 100 km, vorzugsweise 10 km ist, um die mikroklimatischen Veränderungen zu berücksichtigen;
  o und deren zeitliche Auflösung einem Zeitschritt Pt entspricht, der kleiner als oder gleich einer Stunde, vorzugsweise einer halben Stunde ist, um die Dynamik der Veränderungen der Sonnenstrahlung zu berücksichtigen, für jeden Tag J, in einer Periode Pe von mindestens fünf Jahren, vorzugsweise mindestens 10 Jahren.

**11.** Verfahren nach einem der Ansprüche 1 bis 10, **dadurch gekennzeichnet, dass** im Unterschritt 5400 der Server 400:

  • eine Rechenschleife in allen Zeitpunkten eines Zeitschritts Pt', der Tage J und einer Periode Pe' durchführt, wobei Pe' kleiner als oder gleich der Periode Pe ist, die von den in 5300 gewonnenen klimatischen Daten abgedeckt ist, wobei der Zeitschritt Pt' kleiner als oder gleich Pt ist,
  • im Rahmen der Phase 5410 zur Berechnung der Gesamtheit der von P empfangenen Sonnenenergie und für alle Zeitpunkte von jedem Schritt Pt' der Schleife Folgendes berechnet:

o die Position der Sonne in Bezug auf die Ebene P 5411,

o vorzugsweise den energetischen Beitrag EPS der Sonne auf der Ebene P 5412,

o vorzugsweise den energetischen Beitrag EPC des Himmelsgewölbes 5413,

o vorzugsweise den energetischen Beitrag EPRM der Reflexion der direkten Sonnenstrahlung an den Masken auf der Ebene P 5414,

o vorzugsweise den energetischen Beitrag EPRS der Reflexion der Sonnenstrahlung am Boden auf der Ebene P 5415,

o und den gesamten energetischen Beitrag ETP auf der Ebene P = EPS + EPC + EPRM + EPRS,

• im Rahmen der Phase 5420 und für alle Zeitpunkte jedes Schritts Pt' der Schleife die von dem Umwandlungskanal erzeugte elektrische Energie durch Multiplizieren von ETP mit dem elektrischen Umwandlungswirkungsgrad RENP des Photovoltaik-Solarzellenpanels oder der Photovoltaik-Solarzellenpanele des Kanals, vorzugsweise dem nominalen Wirkungsgrad RENPNOM bei 25˚C, vorzugsweise durch Abziehen der durch den Kanal erzeugten Verluste, berechnet,

• im Rahmen der Phase 5421 und für alle Zeitpunkte jedes Schritts Pt' der Schleife RENP, vorzugsweise RENPNOM bei 25˚C, unter Verwendung vorzugsweise eines thermodynamischen Modells berechnet, gemäß dem die Temperatur TP des Photovoltaik-Solarzellenpanels oder der Photovoltaik-Solarzellenpanele anhand von ETP, der Temperatur der Luft TAE im betrachteten Schritt Pt' sowie der Temperatur der Photovoltaikpanele im vorangehenden Schritt Pt' der Schleife bestimmt wird.

**12.** Verfahren nach einem der Ansprüche 1 bis 11, **dadurch gekennzeichnet, dass** der Server mit dem Internet verbunden werden kann und mindestens einen Computer, vorzugsweise einen Personalcomputer, der sich an einem Ort des Operators befindet, und/oder mindestens ein auf eine Internetseite ausgelagertes Datenverarbeitungssystem aufweist.

**13.** Vorrichtung, insbesondere für die Ausführung des Verfahrens nach einem der Ansprüche 1 bis 12, zur Auswertung des Stromerzeugungspotentials einer Ebene P mit beliebiger Neigung und Orientierung, die mindestens ein Photovoltaik-Solarzellenpanel aufweist oder aufweisen soll, wobei das Panel in einem Kanal zur Umwandlung der Sonnenergie in elektrische Energie enthalten ist, der auch mindestens einen Wechselrichter und eine Verkabelung aufweist, **dadurch gekennzeichnet, dass** sie aufweist

➢ ein intelligentes Gehäuse (100) zur automatischen Charakterisierung von P und der Umgebung der Ebene P, das insbesondere enthält:

♦ (110) ein globales Satelliten-Positionsbestimmungssystem, das Ortsbestimmungsdaten von P liefern kann;

♦ (120) mindestens zwei vorteilhafterweise elektronische Neigungsmesser, vorzugsweise mindestens drei Beschleunigungsmesser, die einen Trieder (x, y, z) bilden, von dem zwei Achsen (x, y) in der Referenzebene P liegen und die Messung der 3 Komponenten ($g_x$, $g_y$, $g_z$) des Gravitationsvektors $\vec{g}$ ermöglichen, der es ermöglicht, zum Vektor mit größter Neigung von P und zur Neigung $\alpha$ 2210 (Neigung von P) ihres Vektors mit größter Neigung in Bezug auf die Horizontale zu gelangen;

♦ 130 mindestens einen vorteilhafterweise elektronischen Kompass, vorzugsweise einen Kompass, der aus einem System zur Messung des Erdmagnetfeldes mit mindestens drei zueinander senkrechten magnetischen Sensoren besteht, die einen Trieder (x', y', z') bilden, der vorzugsweise zum Trieder (x, y, z) identisch ist, der es ermöglicht, die Koordinaten ($B_x$, $B_y$, $B_z$) des Vektors des Erdmagnetfeldes $\vec{B}$ im Koor-dinatensystem (x, y, z) zu messen, wobei die Koordinaten es ermöglichen, zum Azimut $\beta$ (Orientierung von P) des Vektors mit größter Neigung von P zu gelangen;

♦ 140 mindestens einen digitalen Photoapparat oder eine Digitalkamera, der/die mit einem Objektiv des Typs "Fischauge" (141), dessen Sehfeldwinkel mindestens 180˚ ist, vorzugsweise mindestens einem CCD-Sensor (142), der mindestens eine Photographie der Umgebung von P aus der Ebene P gesehen aufnehmen kann, ausgestattet ist;

♦ (150) eine elektronische Einheit, die aufweist:

• 151 mindestens einen Ablagespeicher, der insbesondere die Archivierung der im Schritt 2000 erfassten Daten ermöglicht;

• 152 mindestens einen Prozessor zur Berechnung und zur Ausführung von mindestens einem der Schritte 2000, 3000 und 4000, vorzugsweise aller;

• 153 mindestens einen Anschluss zur Verbindung und zur Identifikation;

• (154) möglicherweise einen Echtzeittaktgeber;

• (155) möglicherweise mindestens ein Steuerorgan, vorzugsweise mindestens einen Druckknopf und/oder mindestens eine Fernbedienung;

• (156) eine elektrische Versorgung, vorzugsweise eine Batterie;

➢ mindestens einen dedizierten Server 400, mit dem das Gehäuse (100) jedes Mal verbunden werden kann, wenn es darum geht, das Stromerzeugungspotential einer Ebene P auszuwerten, wobei der Server 400 vorzugsweise ein auf eine Internetseite ausgelagertes Datenverarbeitungssystem ist, das seinerseits mit dem Internet und insbesondere mit einer mikroklimatischen Datenbank verbunden werden kann;

wobei auf das eventuelle ausgelagerte Datenverarbeitungssystem, das im Server 400 enthalten ist, und auf die mikroklimatische Datenbank vorzugsweise über das Internet auf einer geeigneten Internetseite zugegriffen werden kann;

wobei der Server 400 vorzugsweise Mittel zum Erfassen und zur Übertragung zum Server einerseits von einem oder mehreren Parametern, die aus der Gruppe ausgewählt sind, die aufweist: die Identifikation des Operators, die Erschaffung eines Projekts, die Leitung von laufenden Projekten, und andererseits Parametern, die für die Berechnung erforderlich sind und aus der Gruppe ausgewählt sind, die die Eigenschaften der Zellen, die in dem Photovoltaik-Solarzellenpanel oder den Photovoltaik-Solarzellenpanelen enthalten sind, und den Typ von in Betracht gezogenem (gezogenen) Panel(en) aufweist, besitzt;

➢ möglicherweise mindestens einen Computer, vorzugsweise einen Personalcomputer, der sich an einem Ort des Operators befindet, der als Vermittler in der Verbindung mit dem Server 400, wenn dieser ein auf eine Internetseite ausgelagertes Datenverarbeitungssystem ist, und/oder als Server 400 nützlich ist.

14. Vorrichtung nach Anspruch 13, **dadurch gekennzeichnet, dass** das Gehäuse (100) mindestens ein Modul (101) enthält, das durch eine Schale begrenzt ist und mindestens eine ebene Oberfläche (102) aufweist, wobei diese ebene Oberfläche (102) als Bezugssystem nützlich ist und in der Ebene P oder in einer zu P parallelen Ebene angeordnet sein soll; wobei alles oder ein Teil der Mittel (110) bis (150) außerdem in diesem Modul (101) vorzugsweise parallel zu dieser ebenen Oberfläche (102) angeordnet ist; wobei die Außenfläche (Auflagefläche) der Sohle (190) des Gehäuses (100) vorzugsweise mit Gleitschutzmitteln ausgestattet ist, die aus einem Belag, beispielsweise aus Kautschuk oder aus Silikon, bestehen.

15. Vorrichtung nach Anspruch 14, **dadurch gekennzeichnet, dass** das Gehäuse (100) dazu entworfen ist, auf der Oberfläche z.B. eines Dachs, die die Ebene P enthält, abgelegt zu werden und sich auf der Oberfläche derart automatisch zu positionieren, dass die als Bezugssystem nützliche Oberfläche (102) in der Ebene P liegt.

16. Vorrichtung nach Anspruch 15, **dadurch gekennzeichnet, dass** die kleinste Abmessung D des Gehäuses (100) ausreichend hoch ist, damit das Gehäuse (100), sobald es auf die Oberfläche (z.B. ein Dach), die die Ebene P enthält, gelegt ist, in einer Ebene liegt, die die Scheitelpunkte der Unregelmäßigkeiten enthält, wobei D vorzugsweise größer als oder gleich dem kleinsten Abstand zwischen zwei aufeinander folgenden Scheitelpunkten der Unregelmäßigkeiten der Oberfläche, z.B. des Dachs, ist, und um zu ermöglichen, dass die Oberfläche (102) des Gehäuses (100) mit P oder mit einer zu P parallelen Ebene zusammenfällt.

17. Vorrichtung nach Anspruch 15 oder 16, **dadurch gekennzeichnet, dass** das Gehäuse (100) mindestens ein Greifmittel, vorzugsweise mindestens eine Leine (170), das auf der Seite lokalisiert ist, die am nächsten zum Schwerpunkt G des Gehäuses (100) liegt, aufweist.

18. Anlage für die Verwendung der Vorrichtung nach einem der Ansprüche 13 bis 17 im Rahmen der Ausführung des Verfahrens nach einem der Ansprüche 1 bis 12, **dadurch gekennzeichnet, dass** sie das Gehäuse (100) und mindestens eine vorzugsweise teleskopische Stange (200) zur Ablage des Gehäuses (100) auf der Oberfläche, z.B. einem Dach, die die Ebene P enthält, aufweist; wobei das Gehäuse (100) vorzugsweise jenes ist, das in Anspruch 13 definiert ist, und die Stange (200) an einem ihrer Enden einen Ring (230) aufweist, an dem das Gehäuse (100) mittels seiner Leine (170) aufgehängt werden kann.

**FIG. 1**

**FIG. 2**

FIG. 3

FIG. 4

FIG. 5

**FIG. 6**

**FIG. 7**

## RÉFÉRENCES CITÉES DANS LA DESCRIPTION

**Documents brevets cités dans la description**

- CN 1664516
- JP 5066153 B
- US 6748327 B
- DE 10144456 A
- EP 1677240 A2

**Littérature non-brevet citée dans la description**

- **Perez.** Modelling daylight availability and irradiance components from direct and global irradiance. *Solar Energy,* 1990, vol. 44 (5
- **D.L. King.** *Photovoltaic Array Performance Model,* Septembre 2003